# EUROPEAN PATENT SPECIFICATION

(11) **EP 2 588 448 B1**
(45) Date of publication and mention of the grant of the patent: **18.10.2017**
(21) Application number: 11801185.7
(22) Date of filing: 01.07.2011
(51) Int. Cl.: C07C 319/18, H01L 51/50, H01L 33/00, H01L 31/042

(54) **COMPOSITION FOR LIGHT-EMITTING PARTICLE-POLYMER COMPOSITE, LIGHT-EMITTING PARTICLE-POLYMER COMPOSITE, AND DEVICE INCLUDING THE LIGHT-EMITTING PARTICLE-POLYMER COMPOSITE**
ZUSAMMENSETZUNG FÜR EINEN LICHTEMITTIERENDEN PARTIKEL-POLYMER-VERBUNDSTOFF, LICHTEMITTIERENDER PARTIKEL-POLYMER-VERBUNDSTOFF UND VORRICHTUNG MIT DEM LICHTEMITTIERENDEN PARTIKEL-POLYMER-VERBUNDSTOFF
COMPOSITION POUR COMPOSITE PARTICULE-POLYMÈRE ÉLECTROLUMINESCENT, COMPOSITE PARTICULE-POLYMÈRE ÉLECTROLUMINESCENT ET DISPOSITIF COMPRENANT LE COMPOSITE PARTICULE-POLYMÈRE ÉLECTROLUMINESCENT

(30) Priority: 01.07.2010 KR 20100063624
(43) Date of publication of application: 08.05.2013
(73) Proprietor: Samsung Electronics Co., Ltd., Suwon-si, Gyeonggi-do 443-742 (KR)
(72) Inventor: KANG, Hyun A, Suwon-si Gyeonggi-do 443-470 (KR); JANG, Eun Joo, Suwon-si Gyeonggi-do (KR); KIM, Young Hwan, Seongnam-si Gyeonggi-don (KR); JUN, Shin Ae, Seongnam-si Gyeonggi-do 463-500 (KR); JANG, Hyo Sook, Hwaseong-si Gyeonggi-do (KR)
(74) Representative: Scheuermann, Erik
(86) International application number: PCT/KR2011/004871
(87) International publication number: WO 2012/002780

(56) References cited:
- WO-A1-00/68297
- US-A1- 2008 152 933
- US-A1- 2008 230 750
- US-A1- 2009 001 395
- US-A1- 2009 096 136
- US-A1- 2009 096 136
- US-A1- 2009 253 805
- US-A1- 2009 294 742
- US-A1- 2011 006 321
- US-A1- 2012 293 063
- M. KONISHI ET AL: "Enhancement of photoluminescence of ZnS:Mn nanocrystals by hybridizing with polymerized acrylic acid", JOURNAL OF LUMINESCENCE, vol. 93, no. 1, 1 May 2001 (2001-05-01), pages 1-8, XP055132584, ISSN: 0022-2313, DOI: 10.1016/S0022-2313(01)00174-0

## Description

### Technical Field

This disclosure relates to a composition for a light emitting particle-polymer composite, a light emitting particle-polymer composite, and a device including the light emitting particle-polymer composite.

### Background Art

Semiconductor nanocrystals, which are also called quantum dots, are a semiconductor material with a nano-sized and crystalline structure, and include hundreds to thousands of atoms.

Since the semiconductor nanocrystals are very small, they have a large surface area per unit volume, and also have a quantum confinement effect. Accordingly, they have unique physicochemical characteristics that differ from the inherent characteristics of a corresponding bulk semiconductor material.

In particular, since optoelectronic properties of nanocrystals may be controlled by adjusting their size, the semiconductor nanocrystals are being actively researched and applied to display devices and biotechnology applications.

Moreover, since the semiconductor nanocrystal does not contain a heavy metal, it has a variety of advantages in that it is environment-friendly and safe for a human body. Therefore, there has been much research on development of a variety of technologies for synthesizing semiconductor nanocrystals having such excellent characteristics and applicability to diverse areas by controlling the size, structure, uniformity, and so forth of the semiconductor nanocrystals.

However, there remains a need for semiconductor nanocrystals having improved properties, such as improved stability, luminous efficacy, color purity, or lifetime, in order to more easily apply the semiconductor nanocrystals to a display device. Konishi et al., Journal of Luminescence Vol. 93, No. 1, pp 1-8, discloseMn²⁺-doped ZnS nanocrystals hybridized with polymerized acrylic acid.
US 2009/253805 A1 discloses modified multifunctional thiol-ene monomers wherein one or more thiols are reacted with a Michael addition reactive double bond compound as well as discloses photocurable thiol-ene formulations comprising thiol-ene monomers including the modified multifunctional thiols.
US 2009/096136 A1 discloses stamp comprised of a thiol-ene polymer, wherein the thiol-ene polymer allows for the creation of micro-scale or nano-scale patterns described as useful in soft or imprint lithography.
WO 00/68297 A1 discloses ene-thiol elastomers comprising the reaction product of a polythiol free of hydrophilic groups and having at least two thiol groups and an aromatic, heterocyclic, aliphatic, or cycloaliphatic polyene having at least two reactive unsaturated carbon to carbon bonds. Furthermore disclosed are ene-thiol elastomers comprising the reaction product of (a) a thiol terminated oligomer comprising the reaction product of a polythiol having two thiol groups and a first polyene or mixture of polyenes having two reactive unsaturated carbon to carbon bonds; and (b) a second polyene or a mixture of polyenes having at least 5 percent functional equivalents of unsaturated carbon to carbon bonds from polyenes having at least three unsaturated carbon to carbon bonds.
US 2012/293063 A1 discloses an optoelectronic device that includes: a light source; an emission layer disposed on the light source and including light emitting particles dispersed in a matrix polymer; and a polymer film disposed on the emission layer.

### Disclosure of Invention

### Technical Problem

An embodiment of this disclosure provides a composition for a light emitting particle-polymer composite and light emitting particle-polymer composite having excellent stability, and being capable of improving device efficiency and lifetime.

Another embodiment of this disclosure provides a device including the light emitting particle-polymer composite.

### Solution to Problem

According to an embodiment of this disclosure, disclosed is a composition for a light emitting particle-polymer composite, the composition including a light emitting particle; a first monomer including at least two thiol groups, each located at a terminal end of the first monomer; and a second monomer including at least two unsaturated carbon-carbon bonds, each located at a terminal end of the second monomer.

According to another embodiment of this disclosure, disclosed is a light emitting particle-polymer composite including a light emitting particle; and a polymer including a polymerization product of a first monomer including at least two thiol groups, each located at a terminal end of the first monomer, and a second monomer including at least two unsaturated carbon-carbon bonds, each located at a terminal end.

The light emitting particle includes a nanocrystal, a phosphor, a pigment, or a combination thereof. The nanocrystal may include a semiconductor nanocrystal, a metal nanocrystal, a metal oxide nanocrystal, or a combination thereof.

The first monomer including at least two thiol (-SH) groups located at a terminal end of the first monomer is represented by the following Chemical Formula 1.

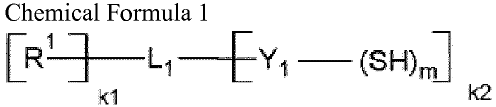

In Chemical Formula 1,
R¹ is hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C3 to C30 cycloalkyl group, a substituted or unsubstituted C3 to C30 heterocycloalkyl group, a substituted or unsubstituted C2 to C30 alkenyl group, a substituted or unsubstituted C2 to C30 alkynyl group, a substituted or unsubstituted C3 to C30 alicyclic group including a ring having a double bond or a triple bond in the ring, a substituted or unsubstituted C3 to C30 heterocycloalkyl group including a ring having a double bond or a triple bond in the ring, a C3 to C30 alicyclic group substituted with a C2 to C30 alkenyl group or a C2 to C30 alkynyl group, a C3 to C30 heterocycloalkyl group substituted with a C2 to C30 alkenyl group or a C2 to C30 alkynyl group, a hydroxyl group, - NH₂, a substituted or unsubstituted C1 to C30 amine group of formula -NRR' wherein R and R' are each independently hydrogen or a C1 to C30 alkyl group, an isocyanate group, an isocyanurate group, a (meth)acrylate group, a halogen, -ROR' wherein R is a substituted or unsubstituted C1 to C20 alkylene group and R¹ is hydrogen or a C1 to C20 alkyl group, an acyl halide of formula -RC(O)X wherein R is a substituted or unsubstituted alkylene group and X is a halogen, -C(=O)OR' wherein R' is hydrogen or a C1 to C20 alkyl group, -CN, or -C(=O)ONRR' wherein R and R' are each independently hydrogen or a C to C20 alkyl group;
L₁ is a single bond, a substituted or unsubstituted C1 to C30 alkylene group, a substituted or unsubstituted C6 to C30 arylene group, a substituted or unsubstituted C3 to C30 heteroarylene group, a substituted or unsubstituted C3 to C30 cycloalkylene group, or a substituted or unsubstituted C3 to C30 heterocycloalkylene group;
Y₁ is a single bond, a substituted or unsubstituted C1 to C30 alkylene group, or a substituted or unsubstituted C2 to C30 alkenylene group; or a C1 to C30 alkylene group or a C2 to C30 alkenylene group wherein at least one methylene group is replaced by a sulfonyl (-SO₂-), a carbonyl (-C(=O)-), an ether (-O-), a sulfide (-S-), a sulfoxide (-SO-), an ester (-C(=O)O-), an amide of formula -C(=O)NR- wherein R is hydrogen or a C1 to C 10 alkyl group, an imine of formula -NR- wherein R is hydrogen or a C 1 to C 10 alkyl group, or a combination thereof;
m is an integer of 1 or more;
k1 is an integer of 0 or 1 or more;
k2 is an integer of 1 or more;
the sum of m and k2 is an integer of 3 or more;
m does not exceed the valance of Y₁; and
k1 and k2 does not exceed the valence of the L₁.

The second monomer is represented by the following Chemical Formula 2.

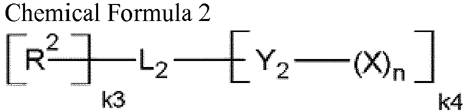

In Chemical Formula 2,
X is a C1 to C30 aliphatic organic group including an unsaturated carbon-carbon bond, a C6 to C30 aromatic organic group including an unsaturated carbon-carbon bond, or a C3 to C30 alicyclic organic group including an unsaturated carbon-carbon bond;
R² is hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C3 to C30 cycloalkyl group, a substituted or unsubstituted C3 to C30 heterocycloalkyl group, a C2 to C30 alkenyl group, a C2 to C30 alkynyl group, a substituted or unsubstituted C3 to C30 alicyclic group including a ring having a double bond or a triple bond in the ring, a substituted or unsubstituted C3 to C30 heterocycloalkyl group including a ring having double bond or a triple bond in the ring, a C3 to C30 alicyclic group substituted with a C2 to C30 alkenyl group or a C2 to C30 alkynyl group, a C3 to C30 heterocycloalkyl group substituted with a C2 to C30 alkenyl group or a C2 to C30 alkynyl group, a hydroxy group, -NH₂, a substituted or unsubstituted C1 to C30 amine group of formula -NRR' wherein R and R' are each independently hydrogen or a C1 to C30 alkyl group, an isocyanate group, an isocyanurate group, a (meth)acrylate group, a halogen, -ROR' wherein R is a substituted or unsubstituted C 1 to C20 alkylene group and R' is hydrogen or a C1 to C20 alkyl group, an acyl halide of formula -RC(O)X wherein R is a substituted or unsubstituted alkylene group and X is a halogen, -C(=O)OR' wherein R' is hydrogen or a C1 to C20 alkyl group, -CN, or -C(=O)ONRR' wherein R and R¹ are each independently hydrogen or a C1 to C20 alkyl group;
L₂ is a single bond, a substituted or unsubstituted C1 to C30 alkylene group, a substituted or unsubstituted C6 to C30 arylene group, or a substituted or unsubstituted C3 to C30 heteroarylene group;
Y₂ is a single bond, a substituted or unsubstituted C1 to C30 alkylene group, or a substituted or unsubstituted C2 to C30 alkenylene group; or a C1 to C30 alkylene group or a C2 to C30 alkenylene group wherein at least one methylene group is replaced by a sulfonyl (-SO₂-), a carbonyl (-C(=O)-), an ether (-O-), a sulfide (-S-), a sulfoxide (-SO-), an ester (-C(=O)O-), an amide of formula -C(=O)NR- wherein R is hydrogen or a C1 to C 10 alkyl group, an imine of formula -NR- wherein R is hydrogen or a C 1 to C 10 alkyl group, or a combination thereof;
n is an integer of 1 or more;
k3 is an integer of 0 or 1 or more;
k4 is an integer of 1 or more;
the sum of n and k4 is an integer of 3 or more;
n does not exceed the valance of Y₂; and
k3 and k4 does not exceed the valence of the L₂.

The first monomer of the above Chemical Formula 1 includes a monomer of the following Chemical Formula 1-1.

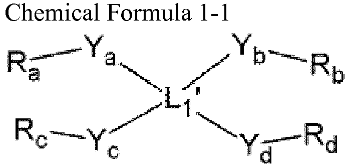

In Chemical Formula 1-1, L₁' is carbon, a substituted or unsubstituted C6 to C30 arylene group, a substituted or a unsubstituted C6 to C30 heteroarylene group, a substituted or unsubstituted C3 to C30 cycloalkylene group, or a substituted or unsubstituted C3 to C30 heterocycloalkylene group;
each of Yₐ to Y_{d} is independently a substituted or unsubstituted C1 to C30 alkylene group; a substituted or unsubstituted C2 to C30 alkenylene group; or a C1 to C30 alkylene group or a C2 to C30 alkenylene group wherein at least one methylene group is replaced by sulfonyl (-S(=O)₂-), carbonyl (-C(=O)-), ether (-O-), sulfide (-S-), sulfoxide (-S(=O)-), ester (-C(=O)O-), amide of formula -C(=O)NR- wherein R is hydrogen or a C1 to C 10 alkyl group, an imine of formula -NR- wherein R is hydrogen or a C 1 to C 10 alkyl group, or a combination thereof; and
Rₐ to R_{d} are R¹ of Chemical Formula 1 or -SH, provided that at least two of Rₐ to R_{d} are -SH.

In an embodiment, L₁' may be a substituted or unsubstituted phenylene group.

Examples of the first monomer of the above Chemical Formula 1 include the compounds represented by the following Chemical Formulas 1-2 to 1-5.

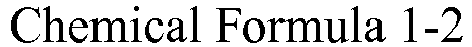

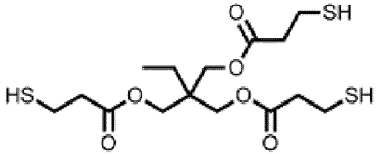

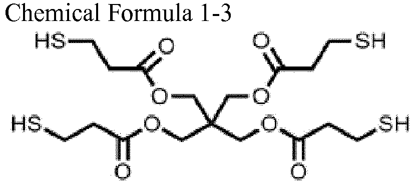

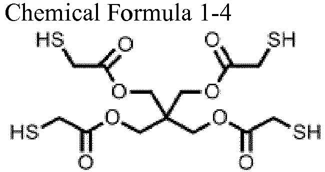

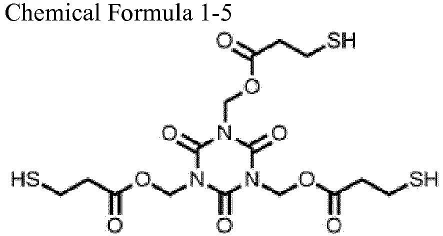

In an embodiment, X may be an acrylate group, a methacrylate group, a C2 to C30 alkenyl group, a C2 to C30 alkynyl group, a substituted or unsubstituted C3 to C30 alicyclic group including a ring having double bond or a triple bond in the ring, a substituted or unsubstituted C3 to C30 heterocycloalkyl group including a ring having double bond or a triple bond in the ring, a C3 to C30 alicyclic group substituted with a C2 to C30 alkenyl group or a C2 to C30 alkynyl group, or a C3 to C30 heterocycloalkyl group substituted with a C2 to C30 alkenyl group or a C2 to C30 alkynyl group.

In Chemical Formula 2, X may be a vinyl group or an allyl group. Also, the substituted or unsubstituted C3 to C30 alicyclic group including the ring having double bond or a triple bond in the ring may be a norbornene group, a maleimide group, a nadimide group, a tetrahydrophthalimide group, or a combination thereof.

In Chemical Formula 2, L₂ may be a pyrrolidine group, a tetrahydrofuran group, a pyridine group, a pyrimidine group, a piperidine group, a triazine group, or an isocyanurate group.

Examples of the second monomer of the above Chemical Formula 2 may include the compounds of the following Chemical Formulae 2-1 and Chemical Formula 2-2.

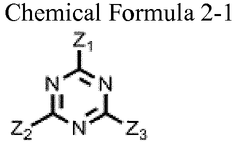

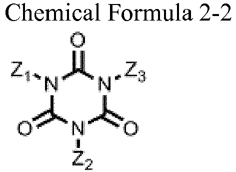

In Chemical Formulas 2-1 and 2-2, Z₁ to Z₃ are the same or different, and correspond to -[Y₂- Xₙ] of Chemical Formula 2.

Examples of the second monomer may include compounds of the following Chemical Formulas 2-3 to 2-5.

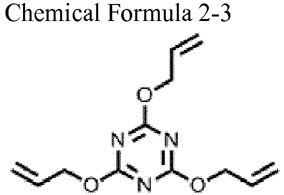

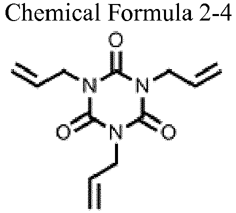

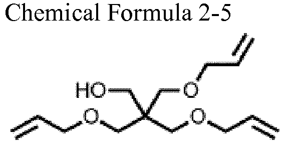

The first monomer and second monomer may be present in an amount of about 80 to about 99.9 weight percent, based on the total weight of the composition for a light emitting particle-polymer composite.

The thiol group of the first monomer and the unsaturated carbon-carbon bond of the second monomer may be present at a mole ratio of 1: about 0.75 to 1:about 1.25.

The composition for a light emitting particle-polymer composite may further include a third monomer having one thiol group located at a terminal end of the third monomer, a fourth monomer having one unsaturated carbon-carbon bond located at a terminal end of the fourth monomer, or a combination thereof.

The light emitting particle may further include a coating, the coating including a polymer having a carboxyl group or a salt thereof. The polymer having a carboxyl group or a salt thereof may include about 1 to about 20 mole percent (mol%) of the carboxyl group or the salt thereof. The polymer having a carboxyl group or a salt thereof may have a melting point ("Tm" of about 50 to about 300°C. The polymer having a carboxyl group or a salt thereof may include poly(alkylene-co-acrylic acid), poly(alkylene-co-methacrylic acid), a salt thereof, or a combination thereof. The polymer having a carboxyl group or a salt thereof may be present in an amount of about 50 to about 10,000 parts by weight, based on 100 parts by weight of the light emitting particle. The coated light emitting particle may be present as a powder or as a film.

According to still another embodiment of this disclosure, an optoelectronic device including the light emitting particle-polymer composite is provided. The optoelectronic device may include a light emitting device such as a light emitting diode ("LED") device or an organic light emitting diode ("OLED"), a memory device, a laser device, or a solar cell.

The light emitting device may include a light source, and the light emitting particle-polymer composite disposed on the light source.

The light emitting particle-polymer composite may be disposed on the light source, and a remaining space of the optoelectronic device may be filled with a resin. The resin may include a silicone resin, an epoxy resin, a (meth)acrylate-based resin, a copolymer of a first monomer including at least two thiol (-SH) groups, each located at a terminal end and a second monomer including at least two unsaturated carbon-carbon bonds, each located at a terminal end of the second monomer, or a combination thereof.

The light emitting device may include a light source, a resin disposed on the light source, a transparent plate covering the resin, and the light emitting particle-polymer composite disposed on the transparent plate. The transparent plate may be made of glass or a transparent polymer.

The light emitting device may further include a polymer film on an outer surface, and the polymer film may include a copolymer of a first monomer including at least two thiol (-SH) groups located at a terminal end of the first monomer, and a second monomer including at least two unsaturated carbon-carbon bonds located at a terminal end of the second monomer, a (meth)acrylate-based resin, a silicone resin, an epoxy resin, or a combination thereof.

Embodiments of this disclosure will be further described in the following detailed description.

### Advantageous Effects of Invention

The composition for a light emitting particle-polymer composite and light emitting particle-polymer composite show excellent stability, and being capable of improving device efficiency and lifetime.

### Brief Description of Drawings

The above and other aspects, advantages and features of this disclosure will become more apparent by describing in further detail exemplary embodiments thereof with reference to the accompanying drawings, in which:

FIGS. 1 to 5 are cross-sectional views of an embodiment of a light emitting diode including an embodiment of a light emitting particle-polymer composite;

FIG. 6 is a cross-sectional view of an embodiment of an electric field light emitting device including a light emitting particle-polymer composite;

FIGS. 7 and 8 respectively show luminance (lumens per watt, lm/W) versus driving time (hours, h) and photoconversion efficiency ("PCE", percent, %) versus driving time (hours, h) of the light emitting diodes according to Examples 7, 8, 10, and 14, and Comparative Examples 1 and 2;

FIG. 9 is a graph of intensity (arbitrary units, a.u.) versus wavelength (nanometers, nm) and shows a light emitting peak of the light emitting diode according to Example 7; and

FIGS. 10 and 11 respectively show luminance (lumens per watt, lm/W) versus driving time (hours, h) and photoconversion efficiency ("PCE", percent, %) versus time (hours, h) of the light emitting diode according to Examples 15, and 17 to 23.

### Best Mode for Carrying out the Invention

This disclosure will be described more fully hereinafter in the following detailed description of this disclosure, in which some but not all embodiments of this disclosure are described.

In the drawings, the thickness of layers, films, panels, regions, etc., are exaggerated for clarity.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"Alkyl" means a straight or branched chain, saturated, monovalent hydrocarbon group (e.g., methyl or hexyl).

"Alkenyl" means a straight or branched chain, monovalent hydrocarbon group having at least one carbon-carbon double bond (e.g., ethenyl (-HC=CH₂)).

"Alkynyl" means a straight or branched chain, monovalent hydrocarbon group having at least one carbon-carbon triple bond (e.g., ethynyl).

"Alkylene" means a straight or branched chain, saturated, aliphatic hydrocarbon group having a valence of at least two, optionally substituted with one or more substituents where indicated, provided that the valence of the alkylene group is not exceeded.

"Alkenylene" means a straight or branched chain, divalent hydrocarbon group having at least one carbon-carbon double bond (e.g., ethenylene (-HC=CH-)).

"Alkoxy" means an alkyl group that is linked via an oxygen (i.e., alkyl-O-), for example methoxy, ethoxy, and sec-butyloxy groups.

"Arene" means a hydrocarbon having an aromatic ring, and includes monocyclic and polycyclic hydrocarbons wherein the additional ring(s) of the polycyclic hydrocarbon may be aromatic or nonaromatic. Specific arenes include benzene, naphthalene, toluene, and xylene.

"Aryl" means a monovalent group formed by the removal of one hydrogen atom from one or more rings of an arene (e.g., phenyl or napthyl).

"Arylene" means a group having a valence of at least two formed by the removal of at least two hydrogen atoms from one or more rings of an arene, wherein the hydrogen atoms may be removed from the same or different rings (e.g., phenylene or napthylene), optionally substituted with one or more substituents where indicated, provided that the valence of the arylene group is not exceeded.

"Aryloxy" means an aryl moiety that is linked via an oxygen (i.e., -O-aryl).

"Alkylaryl" means an alkyl group covalently linked to a substituted or unsubstituted aryl group that is linked to a compound (e.g., methyl-phenylene).

"Cycloalkyl" means a monovalent group having one or more saturated rings in which all ring members are carbon (e.g., cycopentyl and cyclohexyl).

"Cycloalkylene" means a cyclic alkylene group, -CₙH₂ₙ₋ₓ, wherein x represents the number of hydrogens replaced by cyclization(s), and having a valence of at least two, optionally substituted with one or more substituents where indicated, provided that the valence of the cycloalkylene group is not exceeded.

"Cycloalkenyl" means a monovalent group having one or more rings and one or more carbon-carbon double bond in the ring, wherein all ring members are carbon (e.g., cyclopentyl and cyclohexyl).

"Cycloalkynyl" means a stable aliphatic monocyclic or polycyclic group having at least one carbon-carbon triple bond, wherein all ring members are carbon (e.g., cyclohexynyl).

The term "substituted" means that the compound or group is substituted with at least one substituent selected independently from a C1 to C30 alkyl group, a C2 to C30 alkynyl group, a C6 to C30 aryl group, a C7 to C30 alkylaryl group, a C1 to C30 alkoxy group, a C1 to C30 aryloxy group, a C1 to C30 heteroalkyl group, a C3 to C30 heteroalkylaryl group, a C3 to C30 alicyclic group, a C3 to C15 cycloalkenyl group, a C6 to C30 cycloalkynyl group, a C2 to C30 heterocycloalkyl group, a halogen (-F, -Cl, -Br, or -I), a hydroxyl group (-OH), a nitro group (-NO₂), a cyano group (-CN), an amino group (-NRR', wherein R and R' are hysrogen or a C1 to C6 alkyl group), an azido group (-N₃), an amidino group (-C(=NH)NH₂), a hydrazino group (-NHNH₂), a hydrazono group (=N(NH₂), an aldehyde group (-C(=O)H), a carbamoyl group (-C(O)NH₂), a thiol group (-SH), an ester group (-C(=O)OR wherein R is a C1 to C6 alkyl group or a C6 to C12 aryl group), a carboxyl group or a salt thereof (-C(=O)OM wherein M is an organic or inorganic cation), a sulfonic acid (-SO₃H) or a salt thereof (-SO₃M wherein M is an organic or inorganic cation), phosphoric acid (-PO₃H₂) or a salt thereof (-PO₃MH or -PO₃M₂ wherein M is an organic or inorganic cation), instead of hydrogen, provided that the substituted atom's normal valence is not exceeded.

Throughout the present disclosure, reference is made to various heterocyclic groups. Within such groups, the term "hetero" means a group that comprises at least one ring member (e.g., 1 to 4 ring members) that is a heteroatom (e.g., 1 to 4 heteroatoms, each independently N, O, S, P, or Si). In each instance, the total number of ring members may be indicated (e.g., a 3- to 10-membered heterocycloalkyl). If multiple rings are present, each ring is independently aromatic, saturated or partially unsaturated and multiple rings, if present, may be fused, pendant, spirocyclic or a combination thereof. Heterocycloalkyl groups comprise at least one non-aromatic ring that contains a heteroatom ring member. Heteroaryl groups comprise at least one aromatic ring that contains a heteroatom ring member. Non-aromatic and/or carbocyclic rings may also be present in a heteroaryl group, provided that at least one ring is both aromatic and contains a ring member that is a heteroatom.

As used herein, the term "aliphatic organic group" refers to a C1 to C30 linear or branched alkyl group.

The term "aromatic organic group" refers to a C6 to C30 aryl group or a C2 to C30 heteroaryl group.

The term "alicyclic organic group" refers to a C3 to C30 cycloalkyl group, a C3 to C30 cycloalkenyl group, or a C3 to C30 cycloalkynyl group.

As used herein, the term "combination thereof' refers to a mixture, a stacked structure, a composite, an alloy, a blend, a reaction product, or the like.

As used herein, (meth)acrylate refers to an acrylate or a methacrylate.

The composition for a light emitting particle-polymer composite according to an embodiment includes a light emitting particle, a first monomer including at least two thiol (-SH) groups, each located at a terminal end of the first monomer, and a second monomer including at least two unsaturated carbon-carbon bonds, each located at a terminal end of the second monomer.

The light emitting particle includes a nanocrystal, a phosphor, a pigment, or a combination thereof. The nanocrystal may include a semiconductor nanocrystal, a metal nanocrystal, a metal oxide nanocrystal, or a combination thereof. The semiconductor nanocrystal may include a Group II-VI compound, a Group III-V compound, a Group IV-VI compound, a Group IV compound, a Group IV element, or a combination thereof, wherein the term "Group" refers to a Group of the Periodic Table of the Elements.

The Group II-VI compound includes a binary compound selected from CdSe, CdTe, ZnS, ZnSe, ZnTe, ZnO, HgS, HgSe, HgTe, MgSe, MgS, or a combination thereof; a ternary compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, or a combination thereof; or a quaternary compound selected from HgZnTeS, CdZnSeS, CdZnSeTe, CdZnSTe, CdHgSeS, CdHgSeTe, CdHgSTe, HgZnSeS, HgZnSeTe, HgZnSTe, or a combination thereof. The Group III-V compound includes a binary compound selected from GaN, GaP, GaAs, GaSb, AlN, AlP, AlAs, AlSb, InN, InP, InAs, InSb, or a combination thereof; a ternary compound selected from GaNP, GaNAs, GaNSb, GaPAs, GaPSb, AlNP, AlNAs, AINSb, AlPAs, AlPSb, InNP, InNAs, InNSb, InPAs, InPSb, GaAlNP, or a combination thereof; or a quaternary compound selected from GaAlNAs, GaAlNSb, GaAlPAs, GaAlPSb, GaInNP, GaInNAs, GaInNSb, GaInPAs, GaInPSb, Inane, InAlNAs, InAlNSb, InAlPAs, InAlPSb, or a combination thereof. The Group IV-VI compound includes a binary compound selected from SnS, SnSe, SnTe, PbS, PbSe, PbTe, or a combination thereof; a ternary compound selected from SnSeS, SnSeTe, SnSTe, PbSeS, PbSeTe, PbSTe, SnPbS, SnPbSe, SnPbTe, or a combination thereof; or a quaternary compound selected from SnPbSSe, SnPbSeTe, SnPbSTe, or a combination thereof. The Group IV element includes Si or Ge, and the Group IV compound includes a binary compound selected from SiC, SiGe, or a combination thereof.

Herein, the element, the binary compound, the ternary compound, or the quaternary compound may be present in a particle having a substantially uniform concentration, or may be present in a particle having different concentration distributions in the same particle. In addition, the particle may have a core/shell structure in which a first semiconductor nanocrystal is surrounded by a second semiconductor nanocrystal. The core and shell may have an interface, and an element of at least one of the core or the shell may have a concentration gradient which decreases in a direction from the surface of the particle to a center of the particle.

The semiconductor nanocrystal may have a particle diameter (e.g., an average largest particle diameter) ranging from about 1 nanometer (nm) to about 100 nm, specifically about 1 nm to about 50 nm, more specifically about 1 nm to about 10 nm, or about 2 nm to about 25 nm. The particle diameter may refer to a longest dimension when the semiconductor nanocrystal does not have a spherical shape.

In addition, the semiconductor nanocrystal may have any shape, and may be spherical, pyramidal, or multi-armed. In an embodiment, the semiconductor nanocrystal may be a cubic nanoparticle, a nanotube, a nanowire, a nanofiber, a nanoplate particle, or the like, or a combination thereof.

In addition, a method of synthesizing the semiconductor nanocrystal according to an embodiment may have no particular limit, and may include any method provided in a related field. For example, it may include the following method. This method of preparing a semiconductor nanocrystal is not limited, but may include any method which may be determined by one of ordinary skill in the art without undue experimentation.

For example, a wet chemical process may be used to provide a semiconductor nanocrystal having a nano-size and even several nano-sizes. Nanocrystal particles may be provided by adding a precursor material to an organic solvent. When the crystal grows, the organic solvent or an organic ligand surrounds the surface of the semiconductor nanocrystal and can control growth of the crystal.

In addition, the synthesized semiconductor nanocrystal may be used to prepare a nanocrystal-resin composite including a resin matrix wherein the nanocrystal is dispersed by being combined with the resin and curing the resin, so that it may be applied to various fields. According to an embodiment, a first monomer including at least two thiol (-SH) groups, each located at a terminal end of the first monomer and a second monomer including at least two unsaturated carbon-carbon bonds, each located at a terminal end of the second monomer are polymerized to provide a polymer that may be used as a matrix to stabilize a nanocrystal.

The phosphor and pigment used in the light emitting particle-polymer composite may be any phosphor and/or pigment without limitation. The phosphor or pigment may have a particle diameter ranging from about 1 nm to about 100 nm, specifically about 1 nm to about 50 nm, more specifically about 1 nm to about 10 nm, or about 2 nm to about 25 nm. The particle diameter may refer to the longest dimension when the semiconductor nanocrystal does not have a spherical shape.

The first monomer including at least two thiol (-SH) groups, each located at a terminal end of the first monomer is represented by the following Chemical Formula 1.

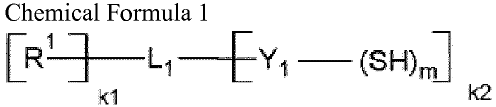

In Chemical Formula 1,
R¹ is hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C3 to C30 cycloalkyl group, a substituted or unsubstituted C3 to C30 heterocycloalkyl group, a substituted or unsubstituted C2 to C30 alkenyl group, a substituted or unsubstituted C2 to C30 alkynyl group, a substituted or unsubstituted C3 to C30 alicyclic group including a ring having a double bond or a triple bond in the ring, a substituted or unsubstituted C3 to C30 heterocycloalkyl group including a ring having a double bond or a triple bond in the ring, a C3 to C30 alicyclic group substituted with a C2 to C30 alkenyl group or a C2 to C30 alkynyl group, a C3 to C30 heterocycloalkyl group substituted with a C2 to C30 alkenyl group or a C2 to C30 alkynyl group, a hydroxyl group, - NH₂, a substituted or unsubstituted C1 to C30 amine group of formula -NRR' wherein R and R' are each independently hydrogen or a C1 to C30 alkyl group, an isocyanate group, an isocyanurate group, a (meth)acrylate group, a halogen, -ROR' wherein R is a substituted or unsubstituted C1 to C20 alkylene group and R' is hydrogen or a C1 to C20 alkyl group, an acyl halide of formula -RC(O)X wherein R is a substituted or unsubstituted alkylene group and X is a halogen, -C(=O)OR' wherein R' is hydrogen or a C1 to C20 alkyl group, -CN, or -C(=O)ONRR' wherein R and R' are each independently hydrogen or a C1 to C20 alkyl group;
L₁ is a single bond, a substituted or unsubstituted C1 to C30 alkylene group, a substituted or unsubstituted C6 to C30 arylene group, or a substituted or unsubstituted C3 to C30 heteroarylene group, a substituted or unsubstituted C3 to C30 cycloalkylene group, or a substituted or unsubstituted C3 to C30 heterocycloalkylene group;
Y₁ is a single bond a substituted or unsubstituted C1 to C30 alkylene group a substituted or unsubstituted C2 to C30 alkenylene group; or a C1 to C30 alkylene group or a C2 to C30 alkenylene group wherein at least one methylene (-CH₂-) group is replaced by a sulfonyl (-SO₂-), a carbonyl (-C(=O)-), an ether (-O-), a sulfide (-S-), a sulfoxide (-SO-), an ester (-C(=O)O-), an amide of formula -C(=O)NR- wherein R is hydrogen or a C1 to C 10 alkyl group, an imine of formula -NR- wherein R is hydrogen or a C 1 to C 10 alkyl group, or a combination thereof;
m is an integer of 1 or more and m does not exceed the valance of Y₁;
k1 is an integer of 0 or 1 or more;
k2 is an integer of 1 or more; and
the sum of m and k2 is an integer of 3 or more.
k1 and k2 does not exceed the valence of the L₁ in Chemical Formula 1.

In an embodiment, the sum of m and k2 is 1 to 6, specifically 2 to 5. In an embodiment, m is 1, k1 is 0, and k2 is 3 to 4.

The second monomer is represented by the following Chemical Formula 2.

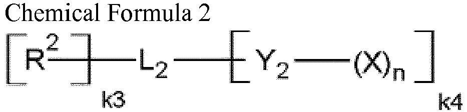

In Chemical Formula 2,
X is a C1 to C30 aliphatic organic group including an unsaturated carbon-carbon bond, a C6 to C30 aromatic organic group including an unsaturated carbon-carbon bond, or a C3 to C30 alicyclic organic group including an unsaturated carbon-carbon bond;
R² is hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C3 to C30 cycloalkyl group, a substituted or unsubstituted C3 to C30 heterocycloalkyl group, a C2 to C30 alkenyl group, a C2 to C30 alkynyl group, a substituted or unsubstituted C3 to C30 alicyclic group including a ring having double bond or a triple bond in the ring, a substituted or unsubstituted C3 to C30 heterocycloalkyl group including a ring having double bond or a triple bond in the ring, a C3 to C30 alicyclic group substituted with a C2 to C30 alkenyl group or a C2 to C30 alkynyl group, a C3 to C30 heterocycloalkyl group substituted with a C2 to C30 alkenyl group or a C2 to C30 alkynyl group, a hydroxy group, -NH₂, a substituted or unsubstituted C1 to C30 amine group of formula -NRR' wherein R and R' are each independently hydrogen or a C1 to C30 alkyl group, an isocyanate group, an isocyanurate group, a (meth)acrylate group, a halogen, -ROR' wherein R is a substituted or unsubstituted C1 to C20 alkylene group and R' is hydrogen or a C1 to C20 alkyl group, an acyl halide of formula -RC(O)X wherein R is a substituted or unsubstituted alkylene group and X is a halogen, -C(=O)OR' wherein R' is hydrogen or a C1 to C20 alkyl group, -CN, or -C(=O)ONRR' wherein R and R' are each independently hydrogen or a C1 to C20 alkyl group;
L₂ is a single bond, a substituted or unsubstituted C1 to C30 alkylene group, a substituted or unsubstituted C6 to C30 arylene group, or a substituted or unsubstituted C3 to C30 heteroarylene group;
Y₂ is a single bond, a substituted or unsubstituted C1 to C30 alkylene group, or a substituted or unsubstituted C2 to C30 alkenylene group; or a C1 to C30 alkylene group or a C2 to C30 alkenylene group wherein at least one methylene (-CH₂-) group is replaced by a sulfonyl (-S(=O)₂-), a carbonyl (-C(=O)-), an ether (-O-), a sulfide (-S-), a sulfoxide (-S(=O)-), an ester (-C(=O)O-), an amide of formula -C(=O)NR-wherein R is hydrogen or a C1 to C 10 alkyl group, an imine of formula -NR- wherein R is hydrogen or a C 1 to C 10 alkyl group, or a combination thereof;
n is an integer of 1 or more and n does not exceed the valance of Y₂;
k3 is an integer of 0 or 1 or more;
k4 is an integer of 1 or more; and
the sum of n and k4 is an integer of 3 or more.
k3 and k4 does not exceed the valence of the L₂ in Chemical Formula 2.

In an embodiment, the sum of n and k4 is 1 to 6, specifically 2 to 5. In another embodiment, n is 1, k3 is 0, and k4 is 3 to 4.

Examples of the first monomer of the above Chemical Formula 1 may include a monomer of the following Chemical Formula 1-1.

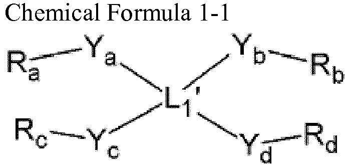

In Chemical Formula 1-1, L₁' is carbon, a substituted or unsubstituted C6 to C30 arylene group, a substituted or a unsubstituted C6 to C30 heteroarylene group, a substituted or unsubstituted C3 to C30 cycloalkylene group, or a substituted or unsubstituted C3 to C30 heterocycloalkylene group;
each of Yₐ to Y_{d} is independently a substituted or unsubstituted C1 to C30 alkylene group; a substituted or unsubstituted C2 to C30 alkenylene group; or a C1 to C30 alkylene group or a C2 to C30 alkenylene group wherein at least one methylene (-CH₂-) group is replaced by sulfonyl (-S(=O)₂-), carbonyl (-C(=O)-), ether (-O-), sulfide (-S-), sulfoxide (-S(=O)-), ester (-C(=O)O-), amide of formula -C(=O)NR-wherein R is hydrogen or a C 1 to C 10 alkyl group, or a combination thereof; and
Rₐ to R_{d} are R¹ of Chemical Formula 1 or -SH, provided that at least two of Rₐ to R_{d} are -SH.

In an embodiment, L₁' is a substituted or unsubstituted phenylene group, and thus the substituted or unsubstituted C6 to C30 arylene group may be a substituted or unsubstituted phenylene group.

Examples of the first monomer of the above Chemical Formula 1 include the compounds represented by of the following Chemical Formulas 1-2 to 1-5.

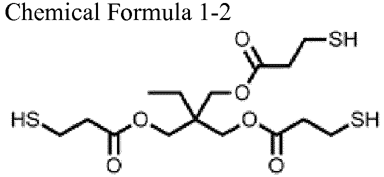

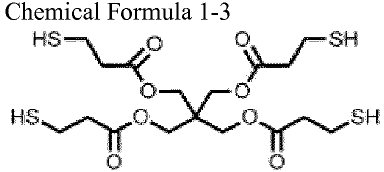

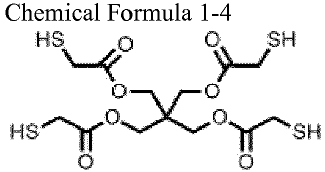

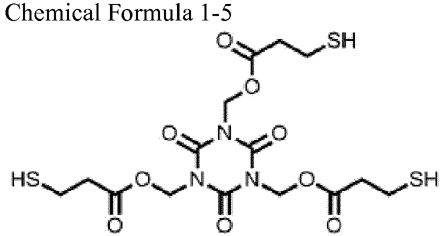

In Chemical Formula 2, X may be a C1 to C30 aliphatic organic group including a carbon-carbon double bond, a C6 to C30 aromatic organic group including a carbon-carbon double bond or a C3 to C30 alicyclic organic group including a carbon-carbon double bond. X may be an acrylate group, a methacrylate group; a C2 to C30 alkenyl group, a C2 to C30 alkynyl group, a substituted or unsubstituted C3 to C30 alicyclic group including a ring having a double bond or a triple bond in the ring, a substituted or unsubstituted C3 to C30 heterocycloalkyl group including a ring having double bond or a triple bond in the ring, a C3 to C30 alicyclic group substituted with a C2 to C30 alkenyl group or a C2 to C30 alkynyl group, or a C3 to C30 heterocycloalkyl group substituted with a C2 to C30 alkenyl group or a C2 to C30 alkynyl group.

In Chemical Formula 2, X may be an alkenyl group, a vinyl group or an allyl group, or a substituted or unsubstituted C3 to C30 alicyclic group including a ring having a double bond or a triple bond in the ring. In an embodiment X may be a norbornene group, a maleimide group, a nadimide group, a tetrahydrophthalimide group, or a combination thereof.

In Chemical Formula 2, L₂ may be a pyrrolidine group, a tetrahydrofuran group, a pyridine group, a pyrimidine group, a piperidine group, a triazine group, or an isocyanurate group.

Examples of the second monomer of the above Chemical Formula 2 may include the compounds of the following Chemical Formulas 2-1 to Chemical Formula 2-2.

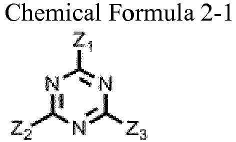

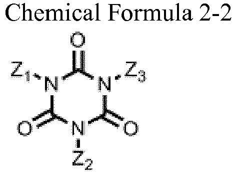

In Chemical Formulas 2-1 and 2-2, Z₁ to Z₃ are the same or different, and correspond to -[Y₂- Xₙ] of Chemical Formula 2.

Examples of the second monomer may include the compounds of the following Chemical Formulas 2-3 to 2-5.

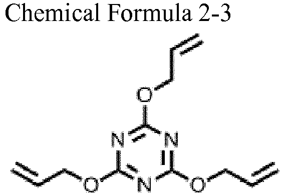

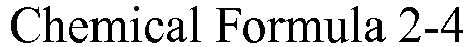

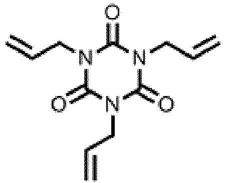

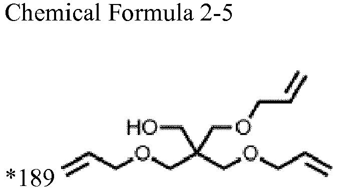

The light emitting particle may be present in an amount of about 0.1 to about 20 weight percent (wt%), specifically about 0.5 to about 15 wt%, more specifically about 1 to about 10 wt%, based on the total weight of the composition for a light emitting particle-polymer composite, and the first monomer and the second monomer may in combination be present in an amount of about 80 to about 99.9 wt%, specifically about 85 to about 99 wt%, more specifically about 90 to about 95 wt%, based on the total weight of the composition for a light emitting particle-polymer composite. A ratio of the weight of the first monomer and the second monomer may be about 0.1:1 to about 1:0.1, specifically about 0.2:1 to about 1:0.2, more specifically about 0.75:1 to about 1:0.75. When the light emitting particle and the first and the second monomers are present within the above ranges, a stable light emitting particle-polymer composite may be provided.

The thiol group of the first monomer and the unsaturated carbon-carbon bond of the second monomer may be present at a mole ratio of 1:about 0.75 to 1:about 1.25. When the first and second monomers are used within the above ranges, a light emitting particle-polymer composite may have a high density network and excellent mechanical strength and barrier properties.

The composition for a light emitting particle-polymer composite may further include a third monomer having one thiol group located at a terminal end of the third monomer, a fourth monomer having one unsaturated carbon-carbon bondlocated at a terminal end of the fourth monomer, or a combination thereof.

The third monomer is the compound represented by Chemical Formula 1 wherein m and k2 are each 1 and the fourth monomer is the compound represented by Chemical Formula 2 wherein n and k4 are each 1.

The light emitting particle may further comprise a coating, the coating comprising a polymer having a carboxyl group or a salt thereof. Thus, the light emitting particle may be pre-coated with a polymer having a carboxyl group or a salt thereof. The carboxyl group may include an acrylic acid group, a methacrylic acid group, or a salt thereof. The polymer having a carboxyl group or a salt thereof may include about 1 to about 100 mol%, specifically about 2 to about 50 mol%, more specifically about 4 to about 20 mol% of a unit including the carboxyl group or a salt thereof. When the unit including a carboxyl group or a salt thereof is included within the above range in the polymer, a stability of the composite may be improved. The polymer may have a melting point ("Tm") of about 50°C to about 300°C, specifically about 60°C to about 250°C, more specifically about 70°C to about 200°C. When the polymer has a melting point within the above range, the polymer may stably coat the light emitting particle.

The coated light emitting particle may be present as a powder or as a film. A coated light emitting particle in a form of a powder and the first and second monomers may be combined to provide a composite, or alternatively, a coated light emitting particle in a form of a film and the first and second monomers may be combined to provide a composite. The polymer having a carboxyl group or a salt thereof may include the carboxyl group or a salt thereof in a long aliphatic chain, for example a C8 to C50, or a C12 to C36 aliphatic chain.

The polymer having a carboxyl group or a salt thereof may include poly(alkylene-co-acrylic acid), poly(alkylene-co-methacrylic acid), a salt thereof, or a combination thereof. The salt may be a compound including a metal such as sodium, zinc, indium, gallium, or the like, instead of hydrogen of the carboxyl group. Examples of the salt include a poly(ethylene-co-acrylic acid) zinc salt, a poly(ethylene-co-methacrylic acid) zinc salt, or the like.

The polymer having a carboxyl group or a salt thereof may be present in an amount of about 50 to about 10,000 parts by weight, specifically about 200 to about 10,000 parts by weight, more specifically about 400 to about 5,000 parts by weight, based on 100 parts by weight of the light emitting particle. In the light emitting particle coated with the polymer having a carboxyl group or a salt thereof, the light emitting particle may be present in an amount of about 1 to about 70 wt%, specifically about 1 to about 50 wt%, more specifically about 2 to about 40 wt%, based on the total weight of the light emitting particle and the polymer having a carboxyl group or a salt thereof. When the composition of the coated light emitting particle is within the foregoing range, a stability of the light emitting particle may be improved.

The composition for a light emitting particle-polymer composite may be cured to provide a light emitting particle-polymer composite wherein a light emitting particle is dispersed in a polymer matrix. The curing process may be performed using ultraviolet ("UV") rays, for example.

In an embodiment, in order to stabilize the light emitting particle during the preparation of the light emitting particle-polymer composite, the light emitting particle and the first monomer may be first combined, and then the second monomer may be subsequently added.

The composition for a light emitting particle-polymer composite may further include an initiator to promote a cross-linking reaction between a thiol group and an unsaturated carbon-carbon bond. The initiator may include phosphine oxide, α-amino ketone, phenylglyoxylate, monoacyl phosphine, benzylmethyl ketal, hydroxyketone, or the like, or combination thereof.

The polymer may have suitable compatibility with the light emitting particle and may be cured at room temperature in a suitable time. Thus, a high temperature process, which may cause deterioration of a stability of a light emitting particle, may be omitted. Also the polymer may form a dense cross-linking structure, and may substantially or effectively prevent permeation of oxygen or moisture, which may originate outside the composite, from contacting and/or reacting with the light emitting particle.

The light emitting particle-polymer composite may stably maintain optical characteristics of the light emitting particle, and it may be applied to various fields. For example, it may be used for an optoelectronic device, for example a light emitting device such as a light emitting diode ("LED") device or an organic light emitting diode ("OLED"), a memory device, a laser device, a solar cell, or like. The light emitting particle-polymer composite may be applied to a physiological field, such as a biotechnology application, or the like.

Hereinafter, a light emitting diode according to an embodiment is further disclosed. Referring to FIGS. 1 to 5, a light emitting diode including a light emitting particle-resin composite as a light emitting material is further disclosed.

FIGS. 1 to 5 are cross-sectional views of an embodiment of a light emitting diode including a light emitting particle-polymer composite.

Referring to FIG. 1, the light emitting diode includes a substrate 104 comprising Ag or the like, a light emitting diode chip 103 emitting in a blue or an ultraviolet ("UV") region on the substrate 104, and a light emitting particle-polymer composite 110 on the light emitting diode chip 103. As a light source of the light emitting diode, a laser, a lamp, or the like, instead of the light emitting diode chip, may be used.

In general, a light emitting particle is disposed on a light emitting diode chip by mixing it with a highly transparent resin such as a silicone resin or an epoxy resin followed by thermal curing. However, the silicone resin has undesirably poor compatibility with the nanocrystal and therefore the resulting composite has reduced efficiency. Also, porosity present after curing is undesirably high, resulting in easy transmission of oxygen or moisture. Also, the epoxy resin has an undesirably low life-span.

In an embodiment, as further described above, a polymer 106 having sufficient compatibility with a light emitting particle 108 and excellent barrier properties for oxygen or moisture is used to provide the composite 110 with the light emitting particle 108.

The light emitting particle 108 may be a red, green, yellow, or blue-emitting light emitting particle 108. The light emitting particle-polymer composite 110 is disposed on a recessed portion of the substrate 104, and covers the light emitting diode chip 103. The light emitting particle-polymer composite 110 is present on the light emitting diode chip 103, and a remaining space may be filled with a resin 112. The light emitting particle-polymer composite 110 may be provided in a film form on the light emitting diode chip 103, but is not limited thereto. Resin 112 is transparent, compatible with the light emitting particle-polymer composite, and suitable for the intended use of the light emitting device. Such a resin 112 may include a silicone resin, an epoxy resin, a (meth)acrylate-based resin, or a copolymer of a first monomer including at least two thiol (-SH) groups located at a terminal end of the first monomer and a second monomer including at least two unsaturated carbon-carbon bonds located at a terminal end of the second monomer.

As shown in FIG. 2, the light emitting particle-polymer composite 110 may be provided by applying a composition for a light emitting particle-polymer composite in a recessed portion of a substrate 104, followed by curing.

Referring to FIG. 3, an embodiment of the light emitting diode includes a substrate 104 comprising Ag or the like, a light emitting diode chip 103 emitting in a blue or ultraviolet ("UV") region on the substrate 104, and a light emitting particle-polymer composite 110 on the light emitting diode chip 103. A resin 112 as described above is disposed in a recessed portion of the substrate 104. Such a resin 112 may include a silicone resin, an epoxy resin, a (meth)acrylate-based resin, or a copolymer of a first monomer including at least two thiol (-SH) groups located at a terminal end of the first monomer and a second monomer including at least two unsaturated carbon-carbon bonds located at a terminal end of the second monomer. A transparent plate 114 is present on the resin 112, and a light emitting particle-polymer composite 110 is present on the transparent plate 114. The transparent plate 114 may comprise glass or a transparent polymer. While not wanting to be bound by theory, it is believed that the structure of FIG. 3 substantially or effectively prevents the light emitting particle 108 from being degraded by a light emitting diode chip 103. FIG. 4 shows a light emitting diode including a polymer film 116 as a barrier film encapsulating an outer surface of the light emitting diode (e.g., on an entire upper surface of the resin 112) shown in FIG. 1, and FIG. 5 shows a light emitting diode including a polymer film 116 encapsulating an outer surface of the light emitting diode (e.g., on entire upper surface of the light emitting particle-polymer composite 110) shown in FIG. 3.

The polymer film 116 comprises a resin having excellent barrier properties for oxygen or moisture, and the resin may be a copolymer of a first monomer including at least two thiol (-SH) groups located at a terminal end of the first monomer and a second monomer including at least two unsaturated carbon-carbon bonds located at a terminal end of the second monomer, a (meth)acrylate-based resin, a silicone resin, an epoxy resin, or combination thereof. The copolymer of the first monomer including at least two thiol (-SH) groups located at a terminal end of the first monomer and the second monomer including at least two unsaturated carbon-carbon bonds located at a terminal end of the second monomer may be prepared through polymerization of the first and second monomers at various mole ratios. Polymerization between the first and second monomers is not limited to a specific mole ratio.

According to an embodiment, a light emitting device is provided that includes a first electrode and a second electrode opposite the first electrode, and the light emitting particle-resin composite between the first electrode and the second electrode.

The light emitting particle 108 absorbs light from the light emitting diode chip 103 and emits light with a different wavelength. In an embodiment, a wavelength of the emitted light is shorter than a wavelength of the light emitted from the light emitting diode chip 103. The light emitting particle 108 may have variously-regulated light emitting wavelengths. For example, a white light emitting diode may be fabricated by combining red and green nano-complex particles with a blue light emitting diode chip. Alternatively, another white light emitting diode may be fabricated by combining red, green, and blue nano-complex particles with an ultraviolet ("UV") light emitting diode chip. A light emitting device which emits light of various wavelengths may be provided by use of light emitting particles which emit light with various wavelengths with a light emitting diode chip.

Referring to FIG. 6, a current-driven light emitting device including a light emitting particle-polymer composite as a light emitting material is further described.

FIG. 6 is a cross-sectional view of an embodiment of a light emitting device including a light emitting particle-polymer composite.

The light emitting device may include an organic light emitting diode ("OLED"), a light emitting diode ("LED" device, a memory device, a laser device, an optoelectronic device, an organic optoelectronic device, or a solar cell. The organic light emitting diode ("OLED") may be fabricated by forming an emission layer between two electrodes. Excitons may be produced by injecting electrons and holes from the two electrodes into the organic emission layer to thereby produce excitons by combination of the electrons and holes. Light is generated when the excitons fall to a ground state from an excited state.

For example, as illustrated in FIG. 6, an OLED includes an anode 52 on an organic substrate 50. The anode 52 may comprise a material having a high work function so that the holes may be injected. Non-limiting examples of the material of the anode 52 include indium tin oxide ("ITO") and a transparent oxide of indium oxide. On the anode 52, a hole transport layer ("HTL") 54, an emission layer ("EL") 56, and an electron transport layer ("ETL") 58 are sequentially disposed. The hole transport layer 54 may include a p-type semiconductor, and the electron transport layer 50 may include an n-type semiconductor or a metal oxide. The emission layer 56 includes the light emitting particle-polymer composite 110. The light emitting particle-polymer composite 110 may be formed by applying it directly or by fabricating it in a film form and then laminating it to provide an emission layer.

A cathode 60 is provided on the electron transport layer 58. The cathode 60 may comprise a material having a low work function so that electrons can be easily injected into the electron transport layer 58. Examples of the material for forming the cathode 60 include a metal, and metal may comprise magnesium, calcium, sodium, potassium, titanium, indium, yttrium, lithium, gadolinium, aluminum, silver, tin, lead, cesium, barium, an alloy thereof, or a combination thereof, and may have a multi-layer structure. The cathode may be a material having a layered structure such as LiF/Al, LiO₂/Al, LiF/Ca, LiF/Al, or BaF₂/Ca, and is not limited thereto. Since a method for fabricating the anode 52, the hole transport layer 54, the emission layer 56, the electron transport layer 58, and the cathode 60 and a method for assembling them are widely known to those skilled in the art and can determined without undue experimentation, these methods will not be further described in detail in this specification.

### Mode for the Invention

Hereinafter, the embodiments are illustrated in more detail with reference to examples. However, the following are exemplary embodiments and shall not be limiting.

### Example 1: Preparation of a nanocrystal-polymer composite

Yellow InP/ZnS/InZnS/ZnS nanocrystal is added to chloroform to prepare a solution having an optical density ("OD" of 0.027 when measured by diluting the solution by 100 times in toluene. A 0.9 milliliter (ml) quantity of the solution is mixed with 0.2 grams (g) of pentaerythritol tetrakis(3-mercaptopropionate) as a first monomer and 0.14 g of 1,3,5-triallyl-1,3,5-triazine-2,4,6(1H,3H,5H)-trione as a second monomer. Then, the solvent is removed from the solution. Next, 100 parts by weight of the mixture of the first and second monomers are mixed with 2 parts by weight of oxy-phenyl-acetic acid 2-[2-oxo-2-phenyl-acetoxy-ethoxy]-ethyl ester. The resulting mixture is polymerized by radiating UV for 10 minutes at a room temperature of about 25°C, to prepare a nanocrystal-polymer composite film.

### Example 2: Preparation of a nanocrystal-polymer composite

Red InP/ZnSeS/ZnS nanocrystal is added to chloroform to prepare a solution having an OD of 0.035 when measured by diluting the solution by 100 times in toluene. A 0.1 ml quantity of the solution is mixed with 0.2 g of pentaerythritol tetrakis(3-mercaptopropionate) as a first monomer and 0.14 g of 1,3,5-triallyl-1,3,5-triazine-2,4,6(1H,3H,5H)-trione as a second monomer. The solvent is removed from the solution. 100 parts by weight of the first and second monomer mixture is mixed with 1 part by weight of oxy-phenyl-acetic acid 2-[2-oxo-2-phenyl-acetoxy-ethoxy]-ethyl ester. The resulting mixture is polymerized by radiating UV at a room temperature of about 25°C for 5 minutes, preparing a nanocrystal-polymer composite film.

### Example 3: Preparation of a nanocrystal-polymer composite

Green InZnP/ZnSeS/ZnS nanocrystal is added to chloroform to prepare a solution having an OD of 0.042 when measured by diluting it by 100 times in toluene. A 0.5 ml quantity of the solution is mixed with a mixture of 0.43 g of pentaerythritol tetrakis (3-mercaptopropionate) as a first monomer and 0.3 g of 1,3,5-triallyl-1,3,5-triazine-2,4,6(1H,3H,5H)-trione as a second monomer. Then, the solvent is removed from the solution. Then, 1 part by weight of oxy-phenyl-acetic acid 2-[2-oxo-2-phenyl-acetoxy-ethoxy]-ethyl ester is mixed with 100 parts by weight of the first and second monomer mixture. The resulting mixture is polymerized by radiating UV at a room temperature of about 25°C for 5 minutes, preparing a nanocrystal-polymer composite film.

### Example 4: Preparation of a nanocrystal-polymer composite

A nanocrystal-polymer composite is prepared according to the same method as Example 1, except for using 2,4,6-triallyloxy-1,3,5 triazine instead of 1,3,5-triallyl-1,3,5-triazine-2,4,6(1H,3H,5H)-trione as a second monomer.

### Example 5: Preparation of a nanocrystal-polymer composite

A nanocrystal-polymer composite is prepared according to the same method as Example 2, except for using 2,4,6-triallyloxy-1,3,5 triazine instead of 1,3,5-triallyl-1,3,5-triazine-2,4,6(1H,3H,SH)-trione as a second monomer.

### Example 6: Preparation of a nanocrystal-polymer composite

A nanocrystal-polymer composite is prepared according to the same method as Example 3, except for using 2,4,6-triallyloxy-1,3,5 triazine instead of 1,3,5-triallyl-1,3,5-triazine-2,4,6(1H,3H,SH)-trione as a second monomer.

### Examples 7 to 12: Fabrication of a light emitting diode ("LED")

A light emitting diode having a structure shown in FIG. 1 is fabricated by preparing a circuit board having a Ag frame and a light emitting diode chip, which emits 445 nm blue light, in a recessed portion of the circuit board. The nanocrystal-polymer composite films according to Examples 1 to 6 are respectively positioned to cover the Ag frame and the light emitting diode chip in the recessed portion of the circuit board. Polydimethylsiloxane resin is filled in an empty space of the circuit board to cover the Ag frame and the light emitting diode chip therein, and cured at 150°C for 2 hours.

### Comparative Examples 1 to 3: Fabrication of a light emitting diode ("LED")

InP/ZnS/InZnS/ZnS, InP/ZnSeS/ZnS, and InZnP/ZnSeS/ZnS are respectively mixed with a polydimethylsiloxane resin. Then, a light emitting diode is fabricated by preparing a circuit board having a Ag frame and a light emitting diode chip, which emits 445 nm blue light, in a recessed portion of the circuit board, disposing the mixture of the nanocrystal and the polydimethylsiloxane resin to cover the Ag frame and the light emitting diode chip in the recessed portion of the circuit board, and curing it at 150°C for 2 hours.

### Examples 13 and 14: Fabrication of a light emitting diode ("LED")

A light emitting diode ("LED") having a structure shown in FIG. 1 is fabricated by preparing a circuit board having a Ag frame and a light emitting diode chip, which emits 445 nm blue light, in a recessed portion of the circuit board, respectively positioning the nanocrystal-polymer composite films of Examples 3 and 2 to cover the Ag frame and the light emitting diode chip in the recessed portion of the circuit board, and then mixing pentaerythritol tetrakis(3-mercaptopropionate) as a first monomer and 1,3,5-triallyl-1,3,5-triazine-2,4,6(1H,3H,5H)-trione as a second monomer in a mole ratio of 3:4, adding 2 parts by weight of oxy-phenyl-acetic acid 2-[2-oxo-2-phenyl-acetoxy-ethoxy]-ethyl ester to 100 parts by weight of the first and second monomers, filling the mixture in the empty space of the recessed portion of the circuit board to cover the composite film, and curing the mixture at room temperature of 25°C for 10 minutes.

The light emitting diodes of Examples 7, 8, 10, and 14, respectively, and the light emitting diodes of Comparative Examples 1 and 2 are operated with a current of 20 milliAmperes (mA) and evaluated regarding luminous efficiency and photoconversion efficiency ("PCE" with respect to driving time. The results are provided in FIGS. 7 and 8, respectively. As shown in FIGS. 7 and 8, the light emitting diodes of Examples 7 and 10 provide excellent initial efficiency and life-span characteristics when compared with Comparative Example 1. Specifically they maintained the same efficiency for about 3800 hours or more,. The light emitting diode according to Example 8 shows better initial efficiency and excellent life-span characteristics when compared with Comparative Example 2. Specifically it maintained the efficiency for about 3300 hours or more. The light emitting diode of Example 14 including the nanocrystal-polymer composites of Example 2 provided improved initial efficiency and excellent life-span characteristics, and maintained efficiency for 2800 hours or more.

FIG. 9 shows a light emitting peak of the light emitting diode according to Example 7. As shown in FIG. 9, it maintained the light emitting peak intensity for more than 3800 hours.

### Example 15: Fabrication of a light emitting diode ("LED")

Red InP/ZnSeS/ZnS nanocrystal is added to chloroform, preparing a solution having an OD of 0.035 when measured by diluting it by 100 times in toluene. A 30 microliter (ml) quantity of the solution is mixed with 0.11 g of pentaerythritol tetrakis(3-mercaptopropionate) as a first monomer and 0.077 g of 1,3,5-triallyl-1,3,5-triazine-2,4,6(1H,3H,5H)-trione as a second monomer. Then, the solvent is removed from the solution. 100 parts by weight of the first and second monomers is mixed with three parts by weight of oxy-phenyl-acetic acid 2-[2-oxo-2-phenyl-acetoxy-ethoxy]-ethyl ester, preparing a composition for a nanocrystal-polymer composite.

Then, a light emitting diode having a structure shown in FIG. 2 is fabricated by preparing a circuit board having a Ag frame and a light emitting diode chip, which emits 445 nm blue light, in a recessed portion of the circuit board, and coating the composition for a nanocrystal-polymer composite to cover the Ag frame and the light emitting diode chip in the recessed portion of the circuit board, and curing it by radiating UV.

### Example 16: Fabrication of a light emitting diode (LED)

Green InZnP/ZnSeS/ZnS nanocrystal is added to chloroform to prepare a solution having an OD of 0.042 when measured by diluting it by 100 times in toluene. A 0.1 ml quantity of the solution is mixed with 0.15 g of pentaerythritol tetrakis(3-mercaptopropionate) as a first monomer and 0.11 g of 1,3,5-triallyl-1,3,5-triazine-2,4,6(1H,3H,5H)-trione as a second monomer. Then, the solvent is removed from the mixture. Then, 1 part by weight of oxy-phenyl-acetic acid 2-[2-oxo-2-phenyl-acetoxy-ethoxy]-ethyl ester is mixed with 100 parts by weight of the first and second monomer mixture.

Next, a light emitting diode having a structure in FIG. 2 is fabricated by preparing a circuit board having a Ag frame and a light emitting diode chip, which emits 445 nm blue light, in a recessed portion of the circuit board, coating the composition to cover the Ag frame and the light emitting diode chip in the recessed portion of the circuit board, and curing the composition by radiating with UV light.

### Example 17: Fabrication of a light emitting diode ("LED")

Yellow InP/ZnS/InZnS/ZnS nanocrystal is coated with poly(ethylene-co-acrylic acid) including 5 wt% of an acrylic acid group having a Tm of 99-101°C to prepare a nanocrystal powder coated with poly(ethylene-co-acrylic acid) on the surface. The nanocrystal is included in an amount of 18 wt% based on the total weight of the poly(ethylene-co-acrylic acid) and the nanocrystal.

The nanocrystal coated with poly(ethylene-co-acrylic acid) is mixed with a mixture of pentaerythritol tetrakis(3-mercaptopropionate) as a first monomer and 1,3,5-triallyl-1,3,5-triazine-2,4,6(1H,3H,SH)-trione as a second monomer mixed in a mole ratio of 3:4 to provide a mixture of the first and second monomers. Next, 1 part by weight of oxy-phenyl-acetic acid 2-[2-oxo-2-phenyl-acetoxy-ethoxy]-ethyl ester is mixed with 100 parts by weight of the mixture of the first and second monomers. Herein, the nanocrystal coated with the poly(ethylene-co-acrylic acid) is included in an amount of 0.77 parts by weight based on 100 parts by weight of pentaerythritol tetrakis(3-mercaptopropionate).

Next, a light emitting diode having a structure of FIG. 2 is fabricated by preparing a circuit board having a Ag frame and a light emitting diode chip, which emits 445 nm blue light, in a recessed portion of the circuit board, filling the mixture in the empty space of the recessed portion in the circuit board to cover the Ag frame and the light emitting diode chip therein, and curing it for 10 minutes at a room temperature of about 25°C.

### Example 18: Fabrication of a light emitting diode ("LED")

A light emitting diode is fabricated according to the same method as Example 17, except for using the nanocrystal coated with poly(ethylene-co-acrylic acid) in an amount of 2.5 parts by weight based on 100 parts by weight of pentaerythritol tetrakis(3-mercaptopropionate) (4T).

### Example 19: Fabrication of a light emitting diode ("LED")

Yellow InP/ZnS/InZnS/ZnS nanocrystal is coated with poly(ethylene-co-acrylic acid) including 5 wt% of an acrylic acid group having a Tm of 99-101°C to prepare a nanocrystal-poly(ethylene-co-acrylic acid) film with a thickness of about 0.1 millimeter (mm). Herein, the yellow nanocrystal is included in an amount of 7 wt%, based on the total weight of the film.

Then, a light emitting diode having a structure of FIG. 2 is fabricated as follows. A circuit board is prepared having a Ag frame and a light emitting diode chip, which emits 445 nm blue light, in a recessed portion. The Ag frame and the light emitting diode chip in the recessed portion of the circuit board are covered with the nanocrystal-poly(ethylene-co-acrylic acid) film. Then, a mixture is prepared by mixing pentaerythritol tetrakis(3-mercaptopropionate) as a first monomer and 1,3,5-triallyl-1,3,5-triazine-2,4,6(1H,3H,54H)-trione as a second monomer in a mole ratio of 3:4, and adding 1 part by weight of oxy-phenyl-acetic acid 2-[2-oxo-2-phenyl-acetoxy-ethoxy]-ethyl ester thereto. The mixture is then filled in the empty space in the recessed portion of the circuit board and the nanocrystal-poly(ethylene-co-acrylic acid) film is cured at a room temperature of about 25°C for 10 minutes.

### Comparative Example 4: Fabrication of a light emitting diode ("LED")

Yellow InP/ZnS/InZnS/ZnS nanocrystal is coated with poly(ethylene-co-acrylic acid) including 5 wt% of an acrylic acid group having a of = 99-101 °C, to prepare a nanocrystal-poly(ethylene-co-acrylic acid) film with a thickness of about 0.1 mm. The yellow nanocrystal is used in an amount of 7 wt%, based on the entire weight of the film.

The nanocrystal-poly(ethylene-co-acrylic acid) film is coated with an epoxy resin and then cured at 80°C for 3 hours, preparing a matrix resin. The matrix resin is used to fabricate a light emitting diode.

### Example 20: Fabrication of a light emitting diode ("LED")

Red InP/ZnSeS/ZnS nanocrystal is coated with poly(ethylene-co-acrylic acid) including 5 wt% of an acrylic acid group having a Tm of 99-101 °C, to prepare a nanocrystal powder coated with the poly(ethylene-co-acrylic acid) on the surface. The nanocrystal is included in an amount of about 11 wt%, based on the total weight of the poly(ethylene-co-acrylic acid) and the nanocrystal. Herein, the nanocrystal poly(ethylene-co-acrylic acid) is used in an amount of 1.1 parts by weight, based on 100 parts by weight of pentaerythritol tetrakis(3-mercaptopropionate).

Next, the pentaerythritol tetrakis(3-mercaptopropionate) as a first monomer and 1,3,5-triallyl-1,3,5-triazine-2,4,6(1H,3H,5H)-trione as a second monomer are mixed in a mole ratio of 3:4. The mixture is mixed with the nanocrystal coated with the poly(ethylene-co-acrylic acid). Then, 1 part by weight of oxy-phenyl-acetic acid 2-[2-oxo-2-phenyl-acetoxy-ethoxy]-ethyl ester is added thereto based on 100 parts of weight of the first and second monomer mixture. Herein, the nanocrystal coated with poly(ethylene-co-acrylic acid) is used in an amount of 1.1 parts by weight, based on 100 parts by weight of pentaerythritol tetrakis(3-mercaptopropionate).

Then, a light emitting diode having a structure shown in FIG. 2 is fabricated by preparing a circuit board having a Ag frame and a light emitting diode chip, which emits 445 nm blue light, in a recessed portion, filling the mixture in the empty space in the recessed portion of the circuit board to cover the Ag frame and the light emitting diode chip in the recessed portion of the circuit board therein, and then curing it at a room temperature of about 25°C for 10 minutes.

### Example 21: Fabrication of a light emitting diode ("LED")

Green InZnP/ZnSeS/ZnS nanocrystal is coated with poly(ethylene-co-acrylic acid) including 5 wt% of an acrylic acid group having a Tm of 99-101°C, to prepare a nanocrystal-poly(ethylene-co-acrylic acid) film with a thickness of about 0.1 mm. The green nanocrystal is included in an amount of 7 wt%, based on the entire weight of the film.

Next, a circuit board is prepared having a Ag frame and a light emitting diode chip, which emits 445 nm blue light, in a recessed portion. The nanocrystal-poly(ethylene-co-acrylic acid) film is positioned to cover the Ag frame and the light emitting diode chip in the recessed portion of the circuit board. Then, pentaerythritol tetrakis(3-mercaptopropionate) as a first monomer and 1,3,5-triallyl-1,3,5-triazine-2,4,6(1H,3H,5H)-trione as a second monomer are mixed in a mole ratio of 3:4. One part by weight of oxy-phenyl-acetic acid 2-[2-oxo-2-phenyl-acetoxy-ethoxy]-ethyl ester is added thereto based on 100 parts by weight of the first and second monomers. The mixture is filled to cover the empty space and the nanocrystal-poly(ethylene-co-acrylic acid) film in the recess portion of the circuit board and then cured at a room temperature of about 25°C for about 10 minutes, fabricating a light emitting diode having a structure shown in FIG. 2.

### Example 22: Fabrication of a light emitting diode ("LED")

Green InZnP/ZnSeS/ZnS nanocrystal is coated with poly(ethylene-co-acrylic acid) including 5 wt% of an acrylic acid group having a Tm of 99-101°C, to prepare a nanocrystal powder coated with the poly(ethylene-co-acrylic acid) on the surface. The nanocrystal is included in an amount of 7 wt%, based on the total weight of poly(ethylene-co -acrylic acid) and the nanocrystal.

Then, pentaerythritol tetrakis(3-mercaptopropionate) as a first monomer is mixed with 1,3,5-triallyl-1,3,5-triazine-2,4,6(1H,3H,5H)-trione as a second monomer in a mole ratio of about 3:4. The nanocrystal coated with poly(ethylene-co-acrylic acid) is added thereto. Then, 1 part by weight of oxy-phenyl-acetic acid 2-[2-oxo-2-phenyl-acetoxy-ethoxy]-ethyl ester is added thereto based on 100 parts by weight of the first and second monomers. Herein, the nanocrystal coated with poly(ethylene-co-acrylic acid) is included in an amount of 13 parts by weight based on 100 parts by weight of the pentaerythritol tetrakis(3-mercaptopropionate).

Then, a light emitting diode having a structure shown FIG. 2 is fabricated by preparing a circuit board having a Ag frame and a light emitting diode chip, which emits 445 nm blue light, in the recessed portion of the circuit board, filling the mixture to cover the Ag frame and the light emitting diode chip in the recessed portion of the circuit board and the empty space therein, and curing the mixture at a room temperature of about 25°C for 10 minutes.

### Example 23: Fabrication of a light emitting diode ("LED")

Green InZnP/ZnSeS/ZnS nanocrystal is coated with poly(ethylene-co-acrylic acid) including 5 wt% of an acrylic acid group having a Tm of 99-101°C, to prepare a nanocrystal-poly(ethylene-co-acrylic acid) film with a thickness of about 01 mm. The green nanocrystal is included in an amount of 13 wt%, based on the total weight of the film.

Next, a circuit board is prepared to include a Ag frame and a light emitting diode, which emits 445 nm blue light, in a recessed portion. Then, a polydimethylsiloxane resin is filled in the recessed portion to cover the Ag frame and the light emitting diode and cured at 150°C for 2 hours. The resulting product is covered with a glass plate. Then, pentaerythritol tetrakis(3-mercaptopropionate) as a first monomer and 1,3,5-triallyl-1,3,5-triazine-2,4,6(1H,3H,5H)-trione as a second monomer are mixed in a mole ratio of 3:4. One part by weight of oxy-phenyl-acetic acid 2-[2-oxo-2-phenyl-acetoxy-ethoxy]-ethyl ester is added thereto based on 100 parts by weight of the first and second monomers. The nanocrystal-poly(ethylene-co-acrylic acid) film is positioned on the glass plate, and the mixture is coated thereon and cured at a room temperature of about 25°C for 10 minutes, fabricating a light emitting diode shown in FIG. 3.

The light emitting diodes according to Examples 15 and 17 to 22 are operated with a current of 20 mA. The light emitting diode of Example 23 is operated with a current of 60 mA. Luminous efficiency and PCE as a function of driving time are measured and the results are respectively provided in FIGS. 10 and 11.

As illustrated in FIGS. 10 and 11, the light emitting diodes according to Example 15, 17, 18, and 20 provide excellent initial efficiency and an excellent life-span characteristic, including stable efficiency for about 2300 hours or more.

The light emitting diodes according to Example 19 provide excellent initial efficiency and life-span characteristics when compared with Comparative Example 4.

The light emitting diodes according to Examples 21 to 22 including nanocrystal coated with poly(ethylene-co-acrylic acid) provide excellent initial efficiency and life-span characteristics.

In particular, the light emitting diode according to Example 23 provides excellent initial efficiency and life-span characteristics at a high current.

## Claims

1. A composition for a light emitting particle-polymer composite, the composition comprising:
a light emitting particle comprising a nanocrystal such as a semiconductor nanocrystal, a metal nanocrystal, a metal oxide nanocrystal, or a combination thereof, a phosphor, a pigment, or a combination thereof;
a first monomer represented by the following Chemical Formula 1: 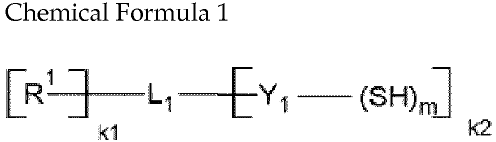
wherein, in Chemical Formula 1,
R¹ is hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C3 to C30 cycloalkyl group, a substituted or unsubstituted C3 to C30 heterocycloalkyl group, a substituted or unsubstituted C2 to C30 alkenyl group, a substituted or unsubstituted C2 to C30 alkynyl group, a substituted or unsubstituted C3 to C30 alicyclic group including a ring having a double bond or a triple bond in the ring, a substituted or unsubstituted C3 to C30 heterocycloalkyl group including a ring having a double bond or a triple bond in the ring, a C3 to C30 alicyclic group substituted with a C2 to C30 alkenyl group or a C2 to C30 alkynyl group, a C3 to C30 heterocycloalkyl group substituted with a C2 to C30 alkenyl group or a C2 to C30 alkynyl group, a hydroxyl group, -NH₂, a substituted or unsubstituted C1 to C30 amine group of formula -NRR' wherein R and R' are each independently hydrogen or a C1 to C30 alkyl group, an isocyanate group, an isocyanurate group, a (meth)acrylate group, a halogen, -ROR' wherein R is a substituted or unsubstituted C1 to C20 alkylene group and R' is hydrogen or a C1 to C20 alkyl group, an acyl halide of formula -RC(O)X wherein R is a substituted or unsubstituted alkylene group and X is a halogen, -C(=O)OR' wherein R¹ is hydrogen or a C1 to C20 alkyl group, -CN, or -C(=O)ONRR' wherein R and R¹ are each independently hydrogen or a C1 to C20 alkyl group;
L₁ is a single bond, a substituted or unsubstituted C1 to C30 alkylene group, a substituted or unsubstituted C6 to C30 arylene group, a substituted or unsubstituted C3 to C30 heteroarylene group, a substituted or unsubstituted C3 to C30 cycloalkylene group, or a substituted or unsubstituted C3 to C30 heterocycloalkylene group;
Y₁ is a single bond; a substituted or unsubstituted C1 to C30 alkylene group; a substituted or unsubstituted C2 to C30 alkenylene group; or a C1 to C30 alkylene group or a C2 to C30 alkenylene group wherein at least one methylene group is replaced by a sulfonyl, a carbonyl, an ether, a sulfide, a sulfoxide, an ester, an amide of formula - C(=O)NR- wherein R is hydrogen or a C1 to C10 alkyl group, an imine of formula -NR-wherein R is hydrogen or a C1 to C10 alkyl group, or a combination thereof;
m is an integer of 1 or more;
k1 is an integer of 0 or 1 or more;
k2 is an integer of 1 or more;
the sum of m and k2 is an integer of 3 or more;
m does not exceed the valance of Y₁; and
k1 and k2 does not exceed the valence of the L₁; and
a second monomer represented by the following Chemical Formula 2: 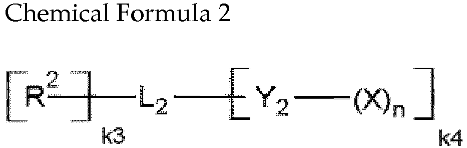
wherein, in Chemical Formula 2,
X is a C1 to C30 aliphatic organic group including an unsaturated carbon-carbon bond, a C6 to C30 aromatic organic group including an unsaturated carbon-carbon bond, or a C3 to C30 alicyclic organic group including an unsaturated carbon-carbon bond;
R² is hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C3 to C30 cycloalkyl group, a substituted or unsubstituted C3 to C30 heterocycloalkyl group, a C2 to C30 alkenyl group, a C2 to C30 alkynyl group, a substituted or unsubstituted C3 to C30 alicyclic group including a ring having double bond or a triple bond in the ring, a substituted or unsubstituted C3 to C30 heterocycloalkyl group including a ring having a double bond or a triple bond in the ring, a C3 to C30 alicyclic group substituted with a C2 to C30 alkenyl group or a C2 to C30 alkynyl group, a C3 to C30 heterocycloalkyl group substituted with a C2 to C30 alkenyl group or a C2 to C30 alkynyl group, a hydroxy group, -NH₂, a substituted or unsubstituted C1 to C30 amine group of formula -NRR' wherein R and R¹ are each independently hydrogen or a C1 to C30 alkyl group, an isocyanate group, an isocyanurate group, a (meth)acrylate group, a halogen, -ROR' wherein R is a substituted or unsubstituted C1 to C20 alkylene group and R' is hydrogen or a C1 to C20 alkyl group, an acyl halide of formula -RC(O)X wherein R is a substituted or unsubstituted alkylene group and X is a halogen, -C(=O)OR' wherein R¹ is hydrogen or a C1 to C20 alkyl group, -CN, or -C(=O)ONRR' wherein R and R¹ are each independently hydrogen or a C1 to C20 alkyl group;
L₂ is a single bond, a substituted or unsubstituted C1 to C30 alkylene group, a substituted or unsubstituted C6 to C30 arylene group, or a substituted or unsubstituted C3 to C30 heteroarylene group;
Y₂ is a single bond; or a substituted or unsubstituted C1 to C30 alkylene group; a substituted or unsubstituted C2 to C30 alkenylene group; or a C1 to C30 alkylene group or a C2 to C30 alkenylene group wherein at least one methylene group is replaced by a sulfonyl, a carbonyl, an ether, a sulfide, a sulfoxide, an ester, an amide of formula-C(=O)NR-wherein R is hydrogen or a C1 to C10 alkyl group, an imine of formula -NR-wherein R is hydrogen or a C1 to C10 alkyl group, or a combination thereof;
n is an integer of 1 or more;
k3 is an integer of 0 or 1 or more;
k4 is an integer of 1 or more;
the sum of n and k4 is an integer of 3 or more;
n does not exceed the valance of Y₂; and
k3 and k4 does not exceed the valence of the L₂.

2. The composition for a light emitting particle-polymer composite of claim 1, wherein the first monomer of the above Chemical Formula 1 comprises a monomer of one of the following Chemical Formulas 1-1 to 1-5: 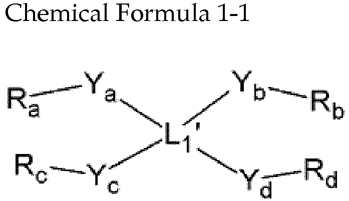
wherein, in Chemical Formula 1-1, L₁' is carbon, a substituted or unsubstituted C6 to C30 arylene group such as a substituted or unsubstituted phenylene group, a substituted or a unsubstituted C3 to C30 heteroarylene group, a substituted or unsubstituted C3 to C30 cycloalkylene group, or a substituted or unsubstituted C3 to C30 heterocycloalkylene group;
each of Yₐ to Yid is independently a substituted or unsubstituted C1 to C30 alkylene group ; a substituted or unsubstituted C2 to C30 alkenylene group; or a C1 to C30 alkylene group or a C2 to C30 alkenylene group wherein at least one methylene group is replaced by sulfonyl, carbonyl, ether, sulfide, sulfoxide, ester, amide of formula -C(=O)NR- wherein R is hydrogen or a C1 to C10 alkyl group, imine of formula -NR- wherein R is hydrogen or a C1 to C10 alkyl group, or a combination thereof; and
Rₐ to R_{d} are R¹ of Chemical Formula 1 or -SH, provided that at least two of Rₐ to R_{d} are -SH;

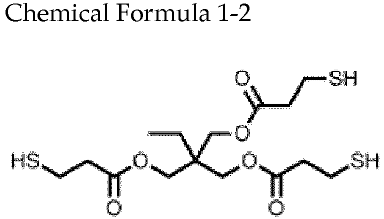

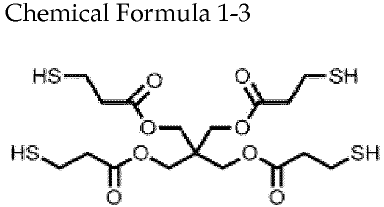

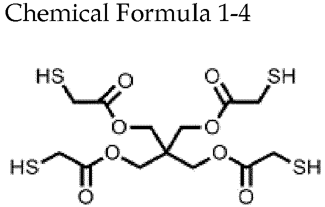

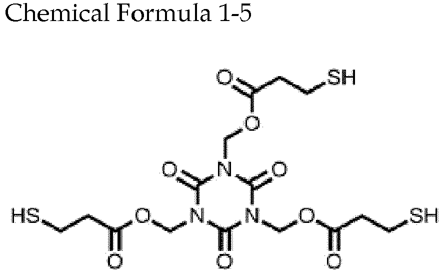

3. The composition for a light emitting particle-polymer composite of claim 1, wherein in Chemical Formula 2, X is a vinyl group, an allyl group, an acrylate group, a methacrylate group, a C2 to C30 alkenyl group, a C2 to C30 alkynyl group, a substituted or unsubstituted C3 to C30 alicyclic group including a ring having a double bond or a triple bond in the ring, a substituted or unsubstituted C3 to C30 heterocycloalkyl group including a ring having a double bond or a triple bond in the ring, a C3 to C30 alicyclic group substituted with a C2 to C30 alkenyl group or a C2 to C30 alkynyl group, or a C3 to C30 heterocycloalkyl group substituted with a C2 to C30 alkenyl group or a C2 to C30 alkynyl group, a norbornene group, a maleimide group, a nadimide group, a tetrahydrophthalimide group, or a combination thereof; and/ or
L₂ is a pyrrolidine group, a tetrahydrofuran group, a pyridine group, a pyrimidine group, a piperidine group, a triazine group, or an isocyanurate group.

4. The composition for a light emitting particle-polymer composite of claim 1, wherein the second monomer of the above Chemical Formula 2 comprises a compound of one of the following Chemical Formula 2-1 to 2-5: 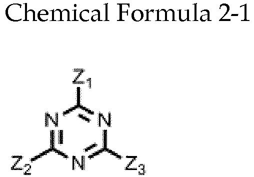 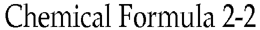 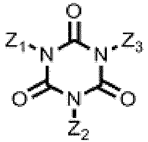 wherein, in Chemical Formulas 2-1 and 2-2, Z₁ to Z₃ are the same or different, and correspond to -[Y₂-Xₙ] of Chemical Formula 2;

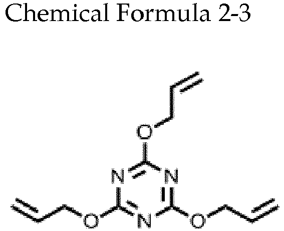

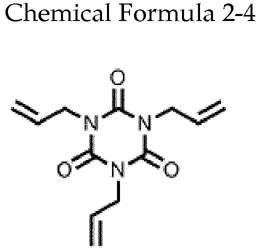

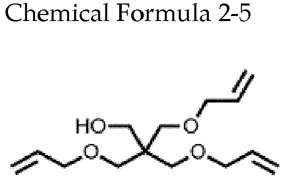

5. The composition for a light emitting particle-polymer composite of any of claims 1-4, further comprising
a third monomer having one thiol group located at a terminal end of the third monomer,
a fourth monomer having an unsaturated carbon-carbon bond located at a terminal end of the fourth monomer, or
a combination thereof.

6. The composition for a light emitting particle-polymer composite of any of claims 1-5, wherein the light emitting particle further comprises a coating, the coating comprising a polymer having a carboxyl group such as poly(alkylene-co-acrylic acid), poly(alkylene-co-methacrylic acid), a salt thereof, or a combination thereof.

7. A light emitting particle-polymer composite comprising a cured product of the composition of any of claims 1-6.

8. An optoelectronic device comprising the light emitting particle-polymer composite according to claim 7, such as a light emitting device, a memory device, a laser device, or a solar cell.

9. The optoelectronic device of claim 8, wherein the light emitting device comprises a light source, and the light emitting particle-polymer composite is disposed on the light source.

10. The optoelectronic device of claim 8 or 9, wherein the light emitting particle-polymer composite is disposed in a form of a film, and a remaining space of the optoelectronic device is filled with a resin contacting the light emitting particle-polymer composite, such as a silicone resin, an epoxy resin, a (meth)acrylate-based resin, a copolymer of a first monomer including at least two thiol groups each located at a terminal end of the first monomer and a second monomer including at least two unsaturated carbon-carbon bonds each located at a terminal end of the second monomer, or a combination thereof.

11. The optoelectronic device of claim 9 or 10, wherein the light emitting device further comprises a transparent plate between the light source and the light emitting particle-polymer composite.

12. The optoelectronic device of any of claims 8-11, wherein the light emitting device further comprises a polymer film at an outer surface, and the polymer film includes a copolymer of a first monomer including at least two thiol groups each located at a terminal end of the first monomer and a second monomer including at least two unsaturated carbon-carbon bonds each located at a terminal end of the second monomer, a (meth)acrylate-based resin, a silicone resin, an epoxy resin, or a combination thereof.

## Patentansprüche

1. Zusammensetzung für einen lichtemittierenden Teilchen-Polymerverbundstoff, wobei die Zusammensetzung Folgendes umfasst:
ein lichtemittierendes Teilchen, das einen Nanokristall sowie einen Halbleiternanokristall umfasst, einen Metallnanokristall, einen Metalloxidnanokristall, oder eine Kombination davon, ein Phosphor, ein Pigment, oder eine Kombination davon; ein erstes Monomer, das durch die folgende chemische Formel 1 dargestellt ist: 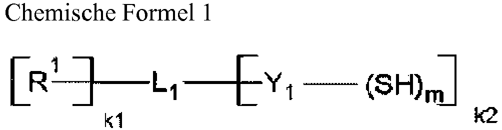
wobei in der chemischen Formel 1,
R¹ für Wasserstoff steht, eine substituierte oder unsubstituierte C1 bis C30 Alkylgruppe, eine substituierte oder unsubstituierte C6 bis C30 Arylgruppe, eine substituierte oder unsubstituierte C3 bis C30 Heteroarylgruppe, eine substituierte oder unsubstituierte C3 bis C30 Cycloalkylgruppe, eine substituierte oder unsubstituierte C3 bis C30 Heterocycloalkylgruppe, eine substituierte oder unsubstituierte C2 bis C30 Alkenylgruppe, eine substituierte oder unsubstituierte C2 bis C30 Alkynylgruppe, eine substituierte oder unsubstituierte C3 bis C30 alicyclische Gruppe, einschließlich eines Ringes, der eine Doppelbindung oder eine Dreifachbindung im Ring aufweist, eine substituierte oder unsubstituierte C3 bis C30 Heterocycloalkylgruppe, einschließlich eines Ringes, der eine Doppelbindung oder eine Dreifachbindung im Ring aufweist, eine C3 bis C30 alicyclische Gruppe substituiert mit einer C2 bis C30 Alkenylgruppe oder einer C2 bis C30 Alkynylgruppe, eine C3 bis C30 Heterocycloalkylgruppe substituiert mit einer C2 bis C30 Alkenylgruppe oder einer C2 bis C30 Alkynylgruppe, eine Hydroxylgruppe, -NH₂, eine substituierte oder unsubstituierte C1 bis C30 Aminogruppe der Formel -NRR` wobei R und R' jeweils unabhängig für Wasserstoff stehen oder eine C1 bis C30 Alkylgruppe, eine Isocyanatgruppe, eine Isocyanuratgruppe, eine (Meth)Acrylatgruppe, ein Halogen, -ROR' wobei R für eine substituierte oder unsubstituierte C1 bis C20 Alkylengruppe steht und R' für Wasserstoff steht oder eine C1 bis C20 Alkylgruppe, ein Acylhalogenid der Formel -RC(O)X, wobei R für eine substituierte oder unsubstituierte Alkylengruppe steht und X für ein Halogen steht, -C(=O)OR`, wobei R' für Wasserstoff steht oder eine C1 bis C20 Alkylgruppe, -CN, oder -C(=O)ONRR', wobei R und R' jeweils unabhängig für Wasserstoff oder eine C1 bis C20 Alkylgruppe steht;
L₁ für eine Einfachbindung steht, eine substituierte oder unsubstituierte C1 bis C30 Alkylengruppe, eine substituierte oder unsubstituierte C6 bis C30 Arylengruppe, eine substituierte oder unsubstituierte C3 bis C30 Heteroarylgruppe, eine substituierte oder unsubstituierte C3 bis C30 Cycloalkylengruppe, oder eine substituierte oder unsubstituierte C3 bis C30 Heterocycloalkylengruppe;
Y₁ für eine Einfachbindung steht; eine substituierte oder unsubstituierte C1 bis C30 Alkylengruppe; eine substituierte oder unsubstituierte C2 bis C30 Alkenylengruppe; oder eine C1 bis C30 Alkylengruppe oder eine C2 bis C30 Alkenylengruppe, wobei mindestens eine Methylengruppe von einem Sulfonyl, einem Carbonyl, einem Ether, einem Sulfid, einem Sulfoxid, einem Ester, einem Amid der Formel - C(=O)NR- ersetzt wird, wobei R für Wasserstoff steht oder eine C1 bis C10 Alkylgruppe, ein Imin der Formel -NR- wobei R für Wasserstoff steht oder eine C1 bis C10 Alkylgruppe, oder eine Kombination davon;
m für eine ganze Zahl von 1 oder mehr steht;
k1 für eine ganze Zahl von 0 oder 1 oder mehr steht;
k2 für eine ganze Zahl von 1 oder mehr steht;
Die Summe von m und k2 für eine ganze Zahl von 3 oder mehr steht;
m die Valenz von Y₁ nicht übertrifft; und
k1 und k2 die Valenz von L1 nicht übertreffen; und
ein zweites Monomer, das durch die folgende chemische Formel 2 dargestellt ist: 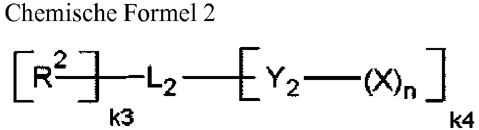
wobei in der chemischen Formel 2,
X für eine C1 bis C30 aliphatische organische Gruppe steht, einschließlich einer ungesättigten Kohlenstoff-Kohlenstoff-Bindung, eine C6 bis C30 aromatische organische Gruppe einschließlich einer ungesättigten Kohlenstoff-Kohlenstoff-Bindung oder eine C3 bis C30 alicyclische organische Gruppe einschließlich einer ungesättigten Kohlenstoff-Kohlenstoff-Bindung;
R² für Wasserstoff steht, eine substituierte oder unsubstituierte C1 bis C30 Alkylgruppe, eine substituierte oder unsubstituierte C6 bis C30 Arylgruppe, eine substituierte oder unsubstituierte C3 bis C30 Heteroarylgruppe, eine substituierte oder unsubstituierte C3 bis C30 Cycloalkylgruppe, eine substituierte oder unsubstituierte C3 bis C30 Heterocycloalkylgruppe, eine substituierte oder unsubstituierte C2 bis C30 Alkenylgruppe, eine substituierte oder unsubstituierte C2 bis C30 Alkynylgruppe, eine substituierte oder unsubstituierte C3 bis C30 alicyclische Gruppe, einschließlich eines Ringes, der eine Doppelbindung oder eine Dreifachbindung im Ring aufweist, eine substituierte oder unsubstituierte C3 bis C30 Heterocycloalkylgruppe, einschließlich eines Ringes, der eine Doppelbindung oder eine Dreifachbindung im Ring aufweist, eine C3 bis C30 alicyclische Gruppe substituiert mit einer C2 bis C30 Alkenylgruppe oder einer C2 bis C30 Alkynylgruppe, eine C3 bis C30 Heterocycloalkylgruppe substituiert mit einer C2 bis C30 Alkenylgruppe oder eine C2 bis C30 Alkynylgruppe, eine Hydroxylgruppe, -NH₂, eine substituierte oder unsubstituierte C1 bis C30 Aminogruppe der Formel -NRR` wobei R und R' jeweils unabhängig für Wasserstoff stehen oder eine C1 bis C30 Alkylgruppe, eine Isocyanatgruppe, eine Isocyanuratgruppe, eine (Meth)Acrylatgruppe, ein Halogen, -ROR' wobei R für eine substituierte oder unsubstituierte C1 bis C20 Alkylengruppe steht und R' für Wasserstoff steht oder eine C1 bis C20 Alkylgruppe, ein Acylhalogenid der Formel -RC(0)X, wobei R für eine substituierte oder unsubstituierte Alkylengruppe steht und X für ein Halogen steht, -C(=O)OR', wobei R' für Wasserstoff steht oder eine C1 bis C20 Alkylgruppe, -CN, oder -C(=O)ONRR', wobei R und R' jeweils unabhängig für Wasserstoff oder eine C1 bis C20 Alkylgruppe stehen;
L₂ für eine Einfachbindung steht, eine substituierte oder unsubstituierte C1 bis C30 Alkylengruppe, eine substituierte oder unsubstituierte C6 bis C30 Arylengruppe, oder eine substituierte oder unsubstituierte C3 bis C30 Heteroarylengruppe;
Y₂ für eine Einfachbindung steht; eine substituierte oder unsubstituierte C1 bis C30 Alkylengruppe; eine substituierte oder unsubstituierte C2 bis C30 Alkenylengruppe; oder eine C1 bis C30 Alkylengruppe oder eine C2 bis C30 Alkenylengruppe, wobei mindestens eine Methylengruppe von einem Sulfonyl, einem Carbonyl, einem Ether, einem Sulfid, einem Sulfoxid, einem Ester, einem Amid der Formel - C(=O)NR- ersetzt wird, wobei R für Wasserstoff steht oder eine C1 bis C10 Alkylgruppe, ein Imin der Formel -NR- wobei R für Wasserstoff steht oder eine C1 bis C10 Alkylgruppe, oder eine Kombination davon;
n für eine ganze Zahl von 1 oder mehr steht;
k3 für eine ganze Zahl von 0 oder 1 oder mehr steht;
k4 für eine ganze Zahl von 1 oder mehr steht;
die Summe von n und k4 für eine ganze Zahl von 3 oder mehr steht;
n die Valenz von Y₂ nicht übertrifft; und
k3 und k4 die Valenz von L₂ nicht übertreffen.

2. Zusammensetzung für einen lichtemittierendes Teilchen-Polymerverbundstoff nach Anspruch 1, wobei das erste Monomer der oben angegebenen Chemischen Formel 1 ein Monomer einer der folgenden Chemischen Formeln 1-1 bis 1-5 umfasst: 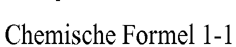 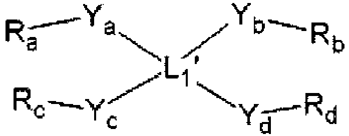
wobei, in der Chemischen Formel 1-1, L₁' für Kohlenstoff steht, eine substituierte oder unsubstituierte C6 bis C30 Arylengruppe, so wie eine substituierte oder unsubstituierte Phenylengruppe, eine substituierte oder unsubstituierte C3 bis C30 Heteroarylgruppe, eine substituierte oder unsubstituierte C3 bis C30 Cycloalkylengruppe, oder eine substituierte oder unsubstituierte C3 bis C30 Heterocycloalkylengruppe;
jede der Yₐ bis Y_{d} unabhängig für eine substituierte oder unsubstituierte C1 bis C30 Alkylengruppe steht; eine substituierte oder unsubstituierte C2 bis C30 Alkenylengruppe; oder eine C1 bis C30 Alkylengruppe oder eine C2 bis C30 Alkenylengruppe, wobei mindestens eine Methylengruppe von Sulfonyl, Carbonyl, Ether, Sulfid, Sulfoxid, Ester, Amid der Formel -C(=O)NR- ersetzt wird, wobei R für Wasserstoff steht oder eine C1 bis C10 Alkylgruppe, Imin der Formel -NR- wobei R für Wasserstoff steht oder eine C1 bis C10 Alkylgruppe, oder eine Kombination davon; und
Rₐ bis R_{d} für R¹ der Chemischen Formel 1 stehen oder -SH, vorausgesetzt, dass mindestens zwei der Rₐ bis R_{d} für -SH stehen;

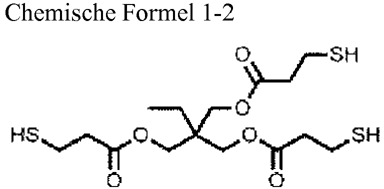

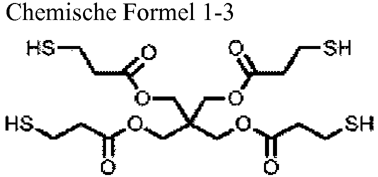

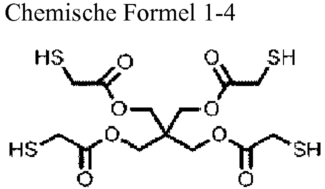

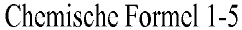

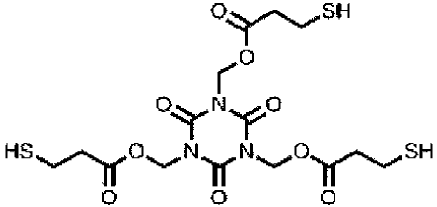

3. Zusammensetzung für einen lichtemittierenden Teilchen-Polymerverbundstoff nach Anspruch 1, wobei in der Chemischen Formel 2, X für eine Vinylgruppe steht, eine Allylgruppe, eine Acrylatgruppe, eine Methacrylatgruppe, eine C2 bis C30 Alkenylgruppe, eine C2 bis C30 Alkynylgruppe, eine substituierte oder unsubstituierte C3 bis C30 alicyclische Gruppe, einschließlich eines Ringes, der eine Doppelbindung oder eine Dreifachbindung im Ring aufweist, eine substituierte oder unsubstituierte C3 bis C30 Heterocycloalkylgruppe, einschließlich eines Ringes, der eine Doppelbindung oder eine Dreifachbindung im Ring aufweist, eine C3 bis C30 alicyclische Gruppe, die mit einer C2 bis C30 Alkenylgruppe oder einer C2 bis C30 Alkynylgruppe substituiert ist oder eine C3 bis C30 Heterocycloalkylgruppe, die mit einer C2 bis C30 Alkenylgruppe substituiert ist, oder einer C2 bis C30 Alkynylgruppe, einer Norbornengruppe, einer Maleimidgruppe, eine Nadimidgruppe, einer Tetrahydrophtalimidgruppe, oder einer Kombination davon; und/oder
L₂ für eine Pyrrolidingruppe steht, eine Tetrahydrofurangruppe, eine Pyridingruppe, eine Pyrimidingruppe, eine Piperidingruppe, eine Triazingruppe oder eine Isocyanuratgruppe.

4. Zusammensetzung für einen lichtemittierenden Teilchen-Polymerverbundstoff nach Anspruch 1, wobei das zweite Monomer der oben angegebenen chemischen Formel 2 eine Verbindung einer der folgenden chemischen Formeln 2-1 bis 2-5 umfasst: 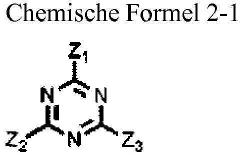 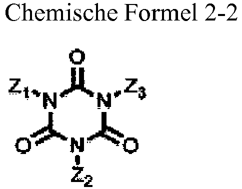 Wobei, in den chemischen Formeln 2-1 und 2-2, Z₁ bis Z₃ gleich oder anders sind und [Y₂-Xₙ] der chemischen Formel 2 entsprechen;

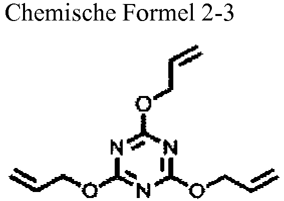

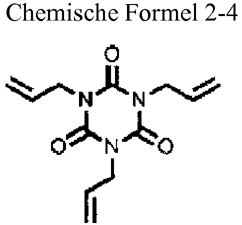

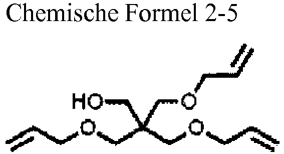

5. Zusammensetzung für einen lichtemittierenden Teilchen-Polymerverbundstoff nach einem der Ansprüche 1-4, die ferner Folgendes umfasst
ein drittes Monomer, das eine Thiolgruppe aufweist, die an einem Anschlussende des dritten Monomers angebracht ist,
ein viertes Monomer, das eine ungesättigte Kohlenstoff-Kohlenstoff-Bindung aufweist, die an einem Anschlussende des vierten Monomers angebracht ist, oder
eine Kombination davon.

6. Zusammensetzung für einen lichtemittierenden Teilchen-Polymerverbundstoff nach einem der Ansprüche 1-5, wobei das lichtemittierende Teilchen ferner eine Beschichtung aufweist, wobei die Beschichtung ein Polymer umfasst, das eine Carboxylgruppe so wie Poly(alkylen-co-acrylsäure) aufweist, Poly(alkylen-co-methacrylsäure), ein Salz davon, oder eine Kombination davon.

7. Lichtemittierender Teilchen-Polymerverbundstoff eines gehärteten Produktes der Zusammensetzung nach einem der Ansprüche 1-6.

8. Optoelektronische Vorrichtung, die den lichtemittierenden Teilchen-Polymerverbundstoff nach Anspruch 7 umfasst, so wie lichtemittierende Vorrichtungen, eine Speichervorrichtung, eine Laservorrichtung, oder eine Solarzelle.

9. Optoelektronische Vorrichtung nach Anspruch 8, wobei die lichtemittierende Vorrichtung eine Lichtquelle umfasst, und der lichtemittierende Teilchen-Polymerverbundstoff an der Lichtquelle angebracht ist.

10. Optoelektronische Vorrichtung nach Anspruch 8 oder 9, wobei der lichtemittierende Teilchen-Polymerverbundstoff in einer Form eines Filmes angebracht ist, und wobei ein verbleibender Raum der optoelektronischen Vorrichtung mit einem Harz gefüllt ist, das den lichtemittierenden Teilchen-Polymerverbundstoff berührt, so wie ein Silikonharz, ein Epoxydharz, ein (Meth)akrylat-basiertes Harz, ein Copolymer eines ersten Monomers, einschließlich mindestens zwei Thiolgruppen, die bei an einem Anschlussende des ersten Monomeres angebracht sind, und ein zweites Monomer, einschließlich mindestens zwei ungesättigten Kohlenstoff-Kohlenstoff-Bindungen, die jeweils an einem Anschlussende des zweiten Monomers angebracht sind, oder eine Kombination davon.

11. Optoelektronische Vorrichtung nach Anspruch 9 oder 10, wobei die lichtemittierende Vorrichtung ferner eine durchsichtige Platte zwischen der Lichtquelle und dem lichtemittierenden Teilchen-Polymerverbundstoff umfasst.

12. Optoelektronische Vorrichtung nach einem der Ansprüche 8-11, wobei die lichtemittierende Vorrichtung ferner einen Polymerfilm an einer äußeren Fläche umfasst, und wobei der Polymerfilm ein Copolymer des ersten Monomers beinhaltet, einschließlich mindestens zwei Thiolgruppen, die jeweils am Anschlussende des ersten Monomers angebracht sind, und ein zweites Monomer, einschließlich mindestens zwei ungesättigten Kohlenstoff-Kohlenstoff-Bindungen, die jeweils am Anschlussende des zweiten Monomers angebracht sind, ein (Meth)acrylat-basiertes Harz, ein Silikonharz, ein Epoxydharz, oder eine Kombination davon.

## Revendications

1. Composition pour un composite de particule électroluminescente-polymère, la composition comprenant :
une particule électroluminescente comprenant un nanocristal tel qu'un nanocristal semi-conducteur, un nanocristal métallique, un nanocristal d'oxyde métallique, ou une combinaison de ceux-ci, un phosphore, un pigment ou une combinaison de ceux-ci ;
un premier monomère représenté par la Formule chimique 1 : 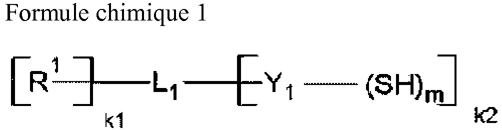
où, dans la Formule chimique 1,
R¹ est l'hydrogène, un groupe alkyle C1 à C30 substitué ou non substitué, un groupe aryle C6 à C30 substitué ou non substitué, un groupe hétéroaryle C3 à C30 substitué ou non substitué, un groupe cycloalkyle C3 à C30 substitué ou non substitué, un groupe hétérocycloalkyle C3 à C30 substitué ou non substitué, un groupe alkényle C2 à C30 substitué ou non substitué, un groupe alkynyle C2 à C30 substitué ou non substitué, un groupe alicyclique C3 à C30 substitué ou non substitué comprenant un noyau comportant une liaison double ou une liaison triple, un groupe hétérocycloalkyle C3 à C30 substitué ou non substitué comprenant un noyau comportant une liaison double ou une liaison triple, un groupe alicyclique C3 à C30 substitué avec un groupe alkényle C2 à C30 ou un groupe alkynyle C2 à C30, un groupe hétérocycloalkyle C3 à C30 substitué avec un groupe alkényle C2 à C30 ou un groupe alkynyle C2 à C30, un groupe hydroxyle, -NH₂, un groupe amine C1 à C30 substitué ou non substitué de la formule -NRR' où R et R' sont chacun indépendamment l'hydrogène ou un groupe alkyle C1 à C30, un groupe isocyanate, un groupe isocyanurate, un groupe (méth)acrylate, un halogène, -ROR' où R est un groupe alkylène C1 à C20 substitué ou non substitué et R¹ est l'hydrogène ou un groupe alkyle C1 à C20, un halure d'acyle de formule -RC(O)X où R est un groupe alkylène substitué ou non substitué et X est un halogène, -C(=O)OR' où R¹ est l'hydrogène ou un groupe alkyle C1 à C20, -CN, ou -C(=O)ONRR' où R et R' sont chacun indépendamment l'hydrogène ou un groupe alkyle C 1 à C20 ;
L₁ est une liaison simple, un groupe alkylène C1 à C30 substitué ou non substitué, un groupe arylène C6 à C30 substitué ou non substitué, un groupe hétéroarylène C3 à C30 substitué ou non substitué, un groupe cycloalkylène C3 à C30 substitué ou non substitué, ou un groupe hétérocycloalkylène C3 à C30 substitué ou non substitué ;
Y₁ est une liaison simple ; un groupe alkylène C1 à C30 substitué ou non substitué ; un groupe alkénylène C2 à C30 substitué ou non substitué ; ou un groupe alkylène C1 à C30 ou un groupe alkénylène C2 à C30 où au moins un groupe méthylène est remplacé par un sulfonyle, un carbonyle, un éther, un sulfure, un sulfoxyde, un ester, un amide de formule - C(=O)NR- où R est l'hydrogène ou un groupe alkyle C1 à C10, une imine de formule -NR- où R est l'hydrogène ou un groupe alkyle C1 à C10, ou une combinaison de ceux-ci ;
m est un nombre entier de 1 ou plus ;
k1 est un nombre entier de 0 ou 1 ou plus ;
k2 est un nombre entier de 1 ou plus ;
la somme de m et k2 est un nombre entier de 3 ou plus ;
m ne dépasse pas la valence de Y₁ ; et
k1 et k2 ne dépassent pas la valence de L₁ ; et
un deuxième monomère représenté par la Formule chimique 2 suivante : 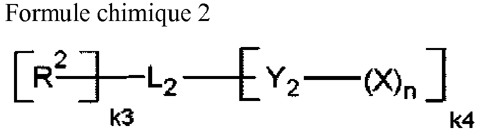
où, dans la Formule chimique 2,
X est un groupe organique aliphatique C1 à C30 comprenant un liaison carbone-carbone non saturée, un groupe organique aromatique C6 à C30 comprenant une liaison carbone-carbone non saturée, ou un groupe organique alicyclique C3 à C30 comprenant une liaison carbone-carbone non saturée ;
R² est l'hydrogène, un groupe alkyle C1 à C30 substitué ou non substitué, un groupe aryle C6 à C30 substitué ou non substitué, un groupe hétéroaryle C3 à C30 substitué ou non substitué, un groupe cycloalkyle C3 à C30 substitué ou non substitué, un groupe hétérocycloalkyle C3 à C30 substitué ou non substitué, un groupe alkényle C2 à C30, un groupe alkynyle C2 à C30, un groupe alicyclique C3 à C30 substitué ou non substitué comprenant un noyau comportant une liaison double ou une liaison triple, un groupe hétérocycloalkyle C3 à C30 substitué ou non substitué comprenant un noyau comportant une liaison double ou une liaison triple, un groupe alicyclique C3 à C30 substitué avec un groupe alkényle C2 à C30 ou un groupe alkynyle C2 à C30, un groupe hétérocycloalkyle C3 à C30 substitué avec un groupe alkényle C2 à C30 ou un groupe alkynyl C2 à C30, un groupe hydroxy, -NH₂, un groupe amine C1 à C30 substitué ou non substitué de formule -NRR' où R et R' sont chacun indépendamment l'hydrogène ou un groupe alkyle C1 à C30, un groupe isocyanate, un groupe isocyanurate, un groupe (méth)acrylate, un halogène, -ROR' où R est un groupe alkylène C1 à C20 substitué ou non substitué et R' est l'hydrogène ou un groupe alkyle C1 à C20, un halure d'acyle de formule -RC(O)X où R est un groupe alkylène substitué ou non substitué et X est un halogène, -C(=O)OR' où R' est l'hydrogène ou un groupe alkyle C1 à C20, -CN, ou -C(=O)ONRR' où R et R' sont chacun indépendamment l'hydrogène ou un groupe alkyle C1 à C20 ;
L₂ est une liaison simple, un groupe alkylène C1 à C30 substitué ou non substitué, un groupe arylène C6 à C30 substitué ou non substitué, ou un groupe hétéroarylène C3 à C30 substitué ou non substitué ;
Y₂ est une liaison simple ; ou un groupe alkylène C1 à C30 substitué ou non substitué ; un groupe alkénylène C2 à C30 substitué ou non substitué ; ou un groupe alkylène C1 à C30 ou un groupe alkénylène C2 à C30 dans lequel au moins un groupe méthylène est remplacé par un sulfonyle, un carbonyle, un éther, un sulfure, un sulfoxyde, un ester, un amide de formule -C(=O)NR- où R est l'hydrogène ou un groupe alkyle C1 à C10, une imine de formule -NR- où R est l'hydrogène ou un groupe alkyle C1 à C10, ou une combinaison de ceux-ci ;
n est un nombre entier de 1 ou plus ;
k3 est un nombre entier de 0 ou 1 ou plus ;
k4 est un nombre entier de 1 ou plus ;
la somme de n et k4 est un nombre entier de 3 ou plus ;
n ne dépasse pas la valence de Y₂ ; et
k3 et k4 ne dépassent pas la valence de L₂.

2. Composition pour composite de particule électroluminescente-polymère selon la revendication 1, dans laquelle le premier monomère de la Formule chimique 1 ci-dessus comprend un monomère des Formules chimiques 1-1 à 1-5 suivantes : 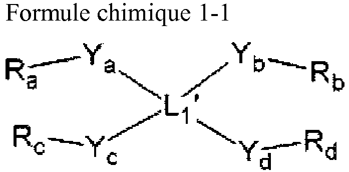
où, dans la Formule chimique 1-1, L₁' est le carbone, un groupe arylène C6 à C30 substitué ou non substitué tel qu'un groupe phénylène substitué ou non substitué, un groupe hétéroarylène C3 à C30 substitué ou non substitué, un groupe cycloalkylène C3 à C30 substitué ou non substitué, ou un groupe hétérocycloalkylène C3 à C30 substitué ou non substitué ;
chacun de Yₐ à Y_{d} est indépendamment un groupe alkylène C1 à C30 substitué ou non substitué ; un groupe alkénylène C2 à C30 substitué ou non substitué ; ou un groupe alkylène C1 à C30 ou un groupe alkénylène C2 à C30 où au moins un groupe méthylène est remplacé par : sulfonyle, carbonyle, éther, sulfure, sulfoxyde, ester, amide de formule -C(=O)NR- où R est l'hydrogène ou un groupe alkyle C1 à C10, imine de formule -NR- où R est l'hydrogène ou un groupe alkyle C1 à C10, ou une combinaison de ceux-ci ; et
Rₐ à R_{d} sont R¹ de Formule chimique 1 ou -SH, étant entendu qu'au moins deux de Rₐ à R_{d} sont-SH;

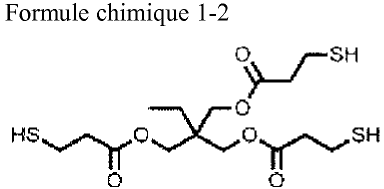

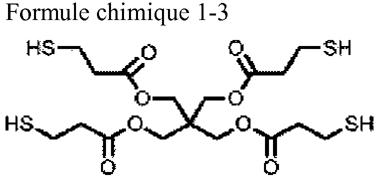

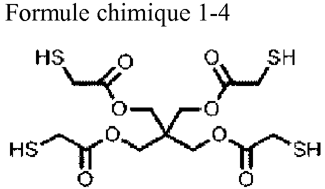

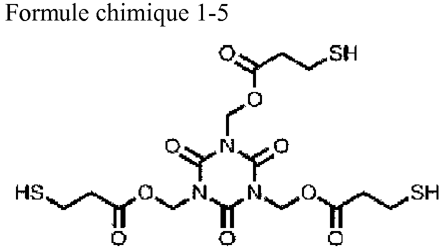

3. Composition pour composite de particule électroluminescente-polymère selon la revendication 1, où, dans la Formule chimique 2, X est un groupe vinyle, un groupe allyle, un groupe acrylate, un groupe méthacrylate, un groupe alkényle C2 à C30, un groupe alkynyle C2 à C30, un groupe alicyclique C3 à C30 substitué ou non substitué comprenant un noyau comportant une liaison double ou une liaison triple, un groupe hétérocycloalkyle C3 à C30 substitué ou non substitué comprenant un noyau comportant une liaison double ou une liaison triple, un groupe alicyclique C3 à C30 substitué avec un groupe alkényle C2 à C30 ou un groupe alkynyle C2 à C30, ou un groupe hétérocycloalkyle C3 à C30 substitué avec un groupe alkényle C2 à C30 ou un groupe alkynyle C2 à C30, un groupe norbornène, un groupe maléimide, un groupe nadimide, un groupe tétrahydrophthalimide, ou une combinaison de ceux-ci ; et/ou
L₂ est un groupe pyrrolidine, un groupe tétrahydrofurane, un groupe pyridine, un groupe pyrimidine, un groupe pipéridine, un groupe triazine, ou un groupe isocyanurate.

4. Composition pour composite de particule électroluminescente-polymère selon la revendication 1, dans laquelle le deuxième monomère de la Formule chimique 2 ci-dessus comprend un composé de l'une des Formules chimiques 2-1 à 2-5 suivantes : 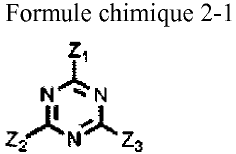 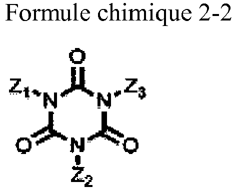 où, dans les Formules chimiques 2-1 et 2-2, Z₁ à Z₃ sont identiques ou différents, et correspondent à -[Y₂-Xₙ] de la Formule chimique 2 ;

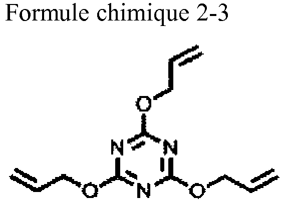

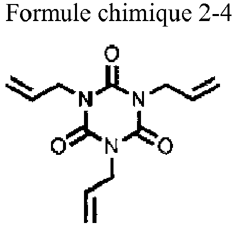

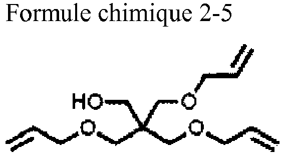

5. Composition pour composite de particule électroluminescente-polymère selon l'une quelconque des revendications 1-4, comprenant en outre
un troisième monomère ayant un groupe thiol situé à une extrémité terminale du troisième monomère,
un quatrième monomère ayant une liaison carbone-carbone non saturée située à une extrémité terminale du quatrième monomère, ou
une combinaison de ceux-ci.

6. Composition pour composite de particule électroluminescente-polymère selon l'une quelconque des revendications 1-5, dans laquelle la particule électroluminescente comprend en outre un revêtement, le revêtement comprenant un polymère ayant un groupe carboxyle tel que poly(alkylène-co-acide acrylique), poly(alkylène-co-acide méthacrylique), un sel de ceux-ci ou une combinaison de ceux-ci.

7. Composite de particule électroluminescente-polymère comprenant un produit durci de la composition selon l'une quelconque des revendications 1-6.

8. Dispositif optoélectronique comprenant le composite de particule électroluminescente-polymère selon la revendication 7, tel qu'un dispositif électroluminescent, un dispositif à mémoire, un dispositif laser ou une cellule solaire.

9. Dispositif optoélectronique selon la revendication 8, dans lequel le dispositif électroluminescent comprend une source lumineuse, et le composite de particule électroluminescente-polymère est disposé sur la source lumineuse.

10. Dispositif optoélectronique selon la revendication 8 ou 9, dans lequel le composite de particule électroluminescente-polymère est disposé sous forme de film, et un espace restant du dispositif optoélectronique est rempli d'une résine en contact avec le composite de particule électroluminescente-polymère, telle qu'une résine de silicone, une résine époxyde, une résine à base de (méth)acrylate, un copolymère d'un premier monomère comprenant au moins deux groupes thiol situés chacun à une extrémité terminale du premier monomère et d'un deuxième monomère comprenant au moins deux liaisons carbone-carbone non saturées situées chacune à une extrémité terminale du deuxième monomère, ou une combinaison de ceux-ci.

11. Dispositif optoélectronique selon la revendication 9 ou 10, dans lequel le dispositif électroluminescent comprend en outre une plaque transparente entre la source lumineuse et le composite de particule électroluminescente-polymère.

12. Dispositif optoélectronique selon l'une quelconque des revendications 8-11, dans lequel le dispositif électroluminescent comprend en outre un film de polymère sur une surface extérieure, et le film de polymère comprend un copolymère d'un premier monomère comprenant au moins deux groupes thiol situés chacun à une extrémité terminale du premier monomère et d'un deuxième monomère comprenant au moins deux liaisons carbone-carbone non saturées situées chacune à une extrémité terminale du deuxième monomère, une résine à base de (méth)acrylate, une résine de silicone, une résine époxyde ou une combinaison de celles-ci.
